# EUROPEAN PATENT APPLICATION

(11) **EP 4 693 592 A1**
(43) Date of publication of application: **11.02.2026**
(21) Application number: 24778020.8
(22) Date of filing: 26.03.2024
(51) Int. Cl.: H01M 10/42, G01R 31/392, H02J 7/00

(54) **BATTERY MANAGEMENT SYSTEM AND METHOD AND ELECTRONIC DEVICE**

(30) Priority: 31.03.2023 CN 202310354014; 07.02.2024 CN 202410175617
(71) Applicant: Huawei Technologies Co., Ltd., Shenzhen, Guangdong 518129 (CN)
(72) Inventor: WANG, Shitong, Shenzhen, Guangdong 518129 (CN); WANG, Bo, Shenzhen, Guangdong 518129 (CN); CHEN, Mengjing, Shenzhen, Guangdong 518129 (CN); DING, Shiming, Shenzhen, Guangdong 518129 (CN)
(74) Representative: Isarpatent
(86) International application number: PCT/CN2024/083855
(87) International publication number: WO 2024/199232

(57) **Abstract**

This application provides a battery management system and method, and an electronic device, to provide a new battery evaluation method, so as to perform more timely and comprehensive battery management, slow down a battery health attenuation speed, and extend a battery service life. In the method, a terminal device displays a battery health report to users on an interface in response to an users' operation of viewing the battery health report. The battery health report provided in embodiments of this application may include but is not limited to a battery health index of the device, aging rate information, interpretation information of a battery state of health, and a target battery management strategy. Compared with a maximum battery capacity, the battery health index provided in the method may be more comprehensive and accurate, and a battery state of health in a full life cycle of the battery are considered.

## Description

### CROSS-REFERENCE TO RELATED APPLICATIONS

This application claims priority to Chinese Patent Application No. 202310354014.2, filed with the China National Intellectual Property Administration on March 31, 2023 and entitled "BATTERY MANAGEMENT SYSTEM AND METHOD, AND ELECTRONIC DEVICE", which is incorporated herein by reference in its entirety. This application claims priority to Chinese Patent Application No. 202410175617.0, filed with the China National Intellectual Property Administration on February 7, 2024 and entitled "BATTERY MANAGEMENT SYSTEM AND METHOD, AND ELECTRONIC DEVICE", which is incorporated herein by reference in its entirety.

### TECHNICAL FIELD

This application relates to the field of electronic technologies, and in particular, to a battery management system and method, and an electronic device.

### BACKGROUND

As devices play an increasingly wide and important role in user's daily life, the need to improve their battery health has become more urgent. In addition to detecting faults, performing repairs, or even replacing batteries after health issues arise, battery lifespan can also be extended by proactively managing battery health.

Currently, battery health management methods include collecting statistics on a maximum battery capacity and optimizing battery charging. The maximum battery capacity may provide users with reference about the battery health, while battery charging optimization may adjust charging strategies based on users' charging habits. However, how to extend the battery lifespan and how to use the battery healthily have important research significance.

### SUMMARY

An objective of this application is to provide a battery management system and method, and an electronic device, to provide a new battery management method, so as to assist users in using batteries more healthily, and extend battery service life.

According to a first aspect, a battery management system is provided, including M devices and a server, where M is a positive integer. The server is configured to separately receive first data collected by the M devices; the server is further configured to: analyze the first data to obtain second data, and obtain a battery analysis result of a first device and/or obtain battery analysis results of the M devices based on the second data, where the first device is any one of the M devices; and the first device is configured to: receive the battery analysis result sent by the server, and display the battery analysis result on a first interface, where the battery analysis result includes at least one of the battery analysis result of the first device or the battery analysis results of the M devices. In some embodiments, that the server analyzes the first data may be implemented as analyzing the first data in a machine learning manner.

The battery analysis result includes a maximum battery capacity, and the battery analysis result further includes and is not limited to one or more of the following information:
(1) a battery health index of a device, where the battery health index of the device is calculated based on at least one of a capacity-type battery health index, a voltage-type battery health index, a resistance-type battery health index, or a discrete-type battery health index included in the second data;
(2) a first aging rate of the battery health index of the device, indicating an attenuation speed of the battery health index of the device;
(3) interpretation information of a battery state of health, indicating a user behavior factor that affects the battery health index of the device and the first aging rate;
(4) a target battery management strategy, where the target battery management strategy is obtained based on at least one of the battery health index of the device and the first aging rate, and is used to update the first aging rate to a second aging rate, and the second aging rate is less than the first aging rate; and
(5) composition of the battery health index of the device, where the composition includes at least one of the capacity-type battery health index, the voltage-type battery health index, the resistance-type battery health index, and the discrete-type battery health index.

Through device-cloud synergy between the device and the server, the server can evaluate the battery state of health of the device in a more comprehensive and timely manner based on the data collected by the device or the plurality of devices. In this way, battery state of health information provided in this embodiment of this application can reflect a capacity status change of the battery, and can reflect the battery state of health with reference to battery data like a battery use behavior. The battery state of health information is equivalent to a battery health report, and may include but is not limited to various possible information related to battery health, to assist a user in paying attention to a change of the battery state of health in a timely and real-time manner, and further enable the user to have a more in-depth and comprehensive understanding of the battery state of health.

In a possible design, the first data includes data of the first device, and the data of the first device includes at least one of the following data content:
battery physical data collected by the first device, which may also be understood as battery physical data defined in a national standard, for example, a voltage, a resistance, and a capacity;
first user behavior data that is collected by the first device on the first interface and that is related to battery management performed by the first device, where when the first device is, for example, a vehicle or an in-vehicle computer, the first interface may be a display interface of the in-vehicle computer, and the battery analysis result may be displayed on the display interface; based on this, the user may view the battery analysis result and perform strategy interaction and feedback on the display interface; in this case, the first user behavior data may include, for example, but is not limited to, stay duration of the user on the display interface, an executed user operation, strategy interaction content, and strategy feedback content; and the first interface may be a display interface of an application displayed by the in-vehicle computer;
second user behavior data that is collected by a second device on a second interface and that is related to battery management performed by the first device, where the second interface is used to display the battery analysis result of the first device; when the first device is, for example, a vehicle or an in-vehicle computer, the second device may be a mobile phone, a tablet computer, or the like that is bound to the user and the in-vehicle computer; and when a mobile phone is used as an example, the battery analysis result of the vehicle can also be displayed on the mobile phone through an application (the application may be, for example, an "Settings" application, or an application specially provided for vehicle management and control) interface, an applet interface, a web interface, and the like;
third user behavior data that is collected by a third device on a third interface and that is related to battery management performed by the first device, where the third interface is used to display the battery analysis results of the M devices; when the first device is, for example, a vehicle or an in-vehicle computer, the third device may be a display device used by a manufacturer, for example, a computer or a notebook computer; and when a notebook computer is used as an example, the notebook computer may also display a battery analysis result of a vehicle of a user, or display battery analysis results of vehicles of users on an entire network, or the like through a web page interface, an installed application software interface, or the like; and
fourth user behavior data that is obtained by the server through analysis and that is related to battery management performed by the first device. It may be understood that, after receiving the data collected by the device, the server may further perform user behavior analysis on the data. For example, the user behavior analysis may include but is not limited to data structure display and analysis, collection frequency display and analysis, output frequency display and analysis, cost calculation display and analysis, and cost optimization display and analysis. An analysis function that can be performed by the server is not limited in this application.

In a possible design, the first device is used in a vehicle including a battery, and the battery analysis result indicates an analysis result of the battery of the vehicle; or the first device is used in an energy storage device including an energy storage battery, and the battery analysis result is an analysis result of the energy storage battery; or the first device is a mobile phone, a tablet computer, or a notebook computer, and the battery analysis result is an analysis result of the energy storage battery.

In a possible design, the second data further includes but is not limited to one or more of the following information: user profile data, environment profile data, battery profile data, device profile data, power generation profile data, power grid profile data, carbon footprint profile data, and production profile data.

In a possible design, the second device is configured to: receive the second data sent by the server, and display the second data on a fourth interface, where the second device is any device that is in the M devices and that is different from the first device.

In a possible design, when the second data includes the user profile data, that the server is configured to obtain the target battery management strategy includes: generating at least one battery management strategy in at least one preset manner; and determining the target battery management strategy from the at least one battery management strategy based on the user profile data.

In a possible design, the at least one preset manner includes a first preset manner; and that the server is configured to generate the at least one battery management strategy in the first preset manner includes: clustering or classifying the M devices based on the first data; determining N devices that belong to a same cluster or category as the first device, where N is a positive integer; determining, from the N devices, a target device whose battery analysis result meets a preset condition; and generating a target battery management strategy of the first device based on a battery management strategy of the target device.

In a possible design, the first device is further configured to collect user feedback data on the first interface, and/or the first device is further configured to collect device feedback data, where the user feedback data indicates a user behavior related to the battery analysis result, and the device feedback data indicates device collection information related to the battery analysis result; the server is further configured to: receive at least one of the user feedback data and the device feedback data that are sent by the first device, and update the user profile data in response to the at least one of the user feedback data and the device feedback data; and the server is further configured to: update and determine the target battery management strategy from the at least one battery management strategy based on updated user profile data.

In a possible design, the interpretation information of the battery state of health indicates a user behavior factor that affects a battery health index and a first aging rate of the first device and the battery health index and the first aging rate of the device; or the interpretation information of the battery state of health indicates a user behavior factor that affects a battery health index and a first aging rate of a type of device that belongs to the same cluster or category as the first device and the battery health index and the first aging rate of the device, where the type of device that belongs to the same cluster or category as the first device is determined based on one or more of the following information: user profile data, environment profile data, battery profile data, device profile data, power generation profile data, carbon footprint profile data, and production profile data.

In a possible design, the user behavior factor includes at least one of a first type of user behavior factor, a second type of user behavior factor, and a third type of user behavior factor, where the first type of behavior factor indicates a user behavior factor that has a first level of impact on the aging rate, where the first level of impact is less than a preset level of impact threshold; the second type of user behavior factor indicates a user behavior factor that has a second level of impact on the aging rate, where the first level of impact is less than the second level of impact; and the third type of user behavior factor indicates a user behavior factor that has a third level of impact on the aging rate, where the second level of impact is less than the third level of impact.

In a possible design, a threshold range is set for the battery health index of the first device. It may be understood that the battery management method provided in this embodiment of this application may be applied to a full life cycle of the device, including but not limited to a period in which the battery is in a good state, a period in which the battery is in a moderate state, a period in which the battery is in an urgently to-be-repaired state, and a period in which the battery is in a faulty state.

In a possible design, the first device is further configured to: when the battery analysis result includes the target battery management strategy, manage a battery of the first device based on the target battery management strategy. In this design, the target battery management strategy included in the obtained battery analysis result can assist the user in battery health management, and can extend battery service life.

In a possible design, the battery analysis result includes the target battery management strategy; and before managing the battery of the first device based on the target battery management strategy, the first device is further configured to: detect a first operation, where the first operation indicates to apply the target battery management strategy, the first operation includes a user operation on a first control or detecting that the first device meets a first preset condition, and the first preset condition includes that the first device obtains an updated target battery management strategy, or the first device detects at least one of a preset application moment or a preset application condition; and download and apply the target battery management strategy in response to the first operation.

In a possible design, the battery analysis result further includes prediction information, and the prediction information indicates at least one of the predicted battery health index of the device and the second aging rate predicted based on the target battery management strategy.

In a possible design, the first device is further configured to: detect a second operation on first information included in the battery analysis result on the first interface, where the first information indicates preview information of the battery health index of the device, preview information of the first aging rate, preview information of the interpretation information of the battery state of health, or preview information of the target battery management strategy; and display a fifth interface in response to the second operation, where the fifth interface indicates detailed information corresponding to the first information.

In a possible design, the first device is further configured to: detect a fourth operation on the composition of the battery health index of the device; and display a sixth interface in response to the fourth operation, where the sixth interface indicates interpretation information of the composition of the battery health index of the device.

In a possible design, when the battery analysis result includes the battery analysis results of the M devices, the first interface further includes one or more of the following information: distribution information of the battery analysis results of the M devices; and ranking information of the battery analysis results of the M devices.

In a possible design, the first device or the server is further configured to: send prompt information to at least one device based on the battery analysis results of the M devices, where the at least one device is a device whose battery state of health meets a preset state of health, and the prompt information indicates the battery state of health corresponding to the device.

In a possible design, aging rate information includes battery health indexes of a plurality of devices within a preset time range, or battery health indexes of devices after a preset quantity of times.

In a possible design, the battery health index of the device is displayed in one or a combination of the following forms: graph, table, text, and voice; and the battery health index is between a first preset index and a second preset index, and the first preset index is less than the second preset index.

Based on the foregoing possible designs, the battery analysis result includes at least one of the following battery types: electrochemical cell, battery module, battery pack, or battery cluster.

According to a second aspect, a battery management method is further provided, applied to a first device. The method includes: detecting a first operation, where the first operation is used to display a battery analysis result; and displaying a first interface in response to the first operation, where the first interface includes the battery analysis result. The battery analysis result includes a maximum battery capacity. The battery analysis result further includes one or more of the following information:
(1) a battery health index of a device, where different battery health indexes are used to reflect different battery states of health;
(2) aging rate information, indicating an attenuation speed of battery health;
(3) interpretation information of a battery state of health, indicating a user behavior factor that affects the battery state of health;
(4) a target battery management strategy, used to update the first aging rate to a second aging rate, where the second aging rate is less than the first aging rate; and
(5) composition of the battery health index of the device, where the composition includes at least one of a capacity-type battery health index, a voltage-type battery health index, a resistance-type battery health index, and a discrete-type battery health index.

According to the method, a battery of a device can be evaluated more comprehensively and timely. In this way, the battery analysis result provided in this embodiment of this application can reflect a capacity status change of the battery, and can reflect the battery state of health with reference to battery data like a battery use behavior. The battery analysis result is equivalent to a battery health report, and may include but is not limited to various possible information related to battery health, to assist a user in paying attention to a change of the battery state of health in a timely and real-time manner, further enable the user to have a more in-depth and comprehensive understanding of the battery state of health, assist the user in battery management, and extend battery service life.

In a possible design, the battery health index of the device includes but is not limited to at least one of the following indexes: a battery health index of the battery (which may be understood as a global battery health index), a capacity-type battery health index, a voltage-type battery health index, a resistance-type battery health index, and a discrete-type battery health index, where the capacity-type battery health index, the voltage-type battery health index, the resistance-type battery health index, and the discrete-type battery health index. The capacity-type battery health index may include but is not limited to: a maximum battery capacity; or a ratio of a maximum battery capacity to a corresponding nominal capacity, which may also be referred to as a battery state of health (state of health, SOH).

In this design, the battery health index obtained in this embodiment of this application may include the battery health index of the battery. The battery health index of the battery may combine a plurality of different types of data of the battery and analysis data of the battery data from different angles, so that the battery state of health can be more comprehensively reflected. In addition, the battery health index obtained in this embodiment of this application may further include a local battery health index. The local battery health index may be classified from various different categories, so that the battery state of health can be reflected from various different perspectives. Compared with a battery capacity index, the battery health index provided in this embodiment of this application can enable the user to more comprehensively understand the battery state of health, so that better battery management can be performed.

In a possible design, the aging rate information indicates a plurality of battery health indexes for a preset period or for a preset quantity of times. It may be understood that the aging rate information may reflect a health change status of the battery from a perspective of at least one feature, for example, an attenuation status of battery health, a capacity attenuation status of the battery, a voltage change status of the battery, a resistance change status of the battery, and a stability status of the battery. In some embodiments, the aging rate information may be further analyzed as a determining basis for detecting a battery fault. For example, when an attenuation speed of a battery health index relative to a previous battery health index exceeds a specific attenuation speed threshold, an alarm, prompt information, a pop-up window, or the like may be sent, so that a battery fault can be checked in time, and/or automatic overhaul processing can be triggered.

In this design, the aging rate information that is of the battery state of health and that is displayed to the user may be presentation of preconfigured historical data, so that a visualization effect of the battery analysis result can be improved, and the user can better understand an attenuation speed of battery health in a period of time or a full life cycle.

In a possible design, the user behavior factor includes at least one of a first type of user behavior factor, a second type of user behavior factor, and a third type of user behavior factor.
(1) The first type of user behavior factor indicates a user behavior factor that has a first level of impact on the aging rate, where the first level of impact is less than a preset level of impact threshold. For example, the first type of user behavior factor may be understood as a good behavioral habit that has a positive effect on maintaining battery health. For another example, the user behavior factor may further include but is not limited to battery usage data in various real working conditions (including but not limited to processes such as device charging, device discharging, and device remaining idle) and environment data (including but not limited to a temperature, a pressure, and humidity).
(2) The second type of user behavior factor indicates a user behavior factor that has a second level of impact on the aging rate, where the first level of impact is less than the second level of impact. For example, the second type of user behavior factor may be understood as a behavior habit that can be improved. For another example, the user behavior factor may further include but is not limited to battery usage data in various real working conditions (including but not limited to processes such as device charging, device discharging, and device remaining idle) and environment data (including but not limited to a temperature, a pressure, and humidity).
(3) The third type of user behavior factor indicates a user behavior factor that has a third level of impact on the aging rate, where the second level of impact is less than the third level of impact. For example, the third type of user behavior factor may be understood as a bad behavior habit that has a negative effect on battery health. For another example, the user behavior factor may further include but is not limited to battery usage data in various real working conditions (including but not limited to processes such as device charging, device discharging, and device remaining idle) and environment data (including but not limited to a temperature, a pressure, and humidity).

In this design, the interpretation information that is of the battery state of health and that is displayed to the user includes a good behavior habit, a behavior habit that can be improved, and a bad behavior habit, so that the user can perform battery management in time, to reduce an attenuation speed of battery health and extend battery service life.

In a possible design, the interpretation information of the battery state of health indicates a user behavior factor that affects the battery state of health of the first device, or the interpretation information of the battery state of health indicates a user behavior factor that affects a battery state of health of a type of device that belongs to a same cluster or category as the first device. The type of device that belongs to a same cluster or category as the first device is determined based on but not limited to one or more of the following information: user profile data, environment profile data, battery profile data, device profile data, power generation profile data, power grid profile data, carbon footprint profile data, and production profile data. The user profile data, the environment profile data, the battery profile data, the device profile data, and the production profile data are concerned features in the field of vehicle-mounted and 3C (a general term of computer, communication, and consumer electronic products) electronic products (such as a mobile phone, a tablet, and a notebook computer). The user profile data, the environment profile data, the battery profile data, the device profile data, the power generation profile data, the power grid profile data, the carbon footprint profile data, and the production profile data are concerned features in the energy storage field (such as a user scenario, a commercial and industrial industry scenario, a utility-scale scenario, a data center scenario, and a site energy scenario).

In this design, the interpretation information of the battery state of health may be obtained based on the user behavior factor of the first device, so that more targeted interpretation information can be obtained, and accuracy of battery management of the first device can be improved. Alternatively, the interpretation information of the battery state of health may be obtained based on a user behavior factor of a type of device similar to the first device, so that a good behavior habit, a behavior habit that can be improved, a bad behavior habit, and the like of the similar device can be comprehensively considered, and accuracy of battery management on the first device can be improved. In this way, the interpretation information of the battery state of health is displayed to the user, so that the user can perform battery management in time, to extend battery service life.

In a possible design, the battery health index is displayed in but not limited to one or a combination of the following forms: a graph, a table, and a text; and the battery health index is between a first preset index and a second preset index, and the first preset index is less than the second preset index. For example, the battery health index may be between 0 and 100, or may be between 100 and 1000. This is not limited in this application.

In this design, the battery health index provided in this embodiment of this application may be displayed in various possible display forms, so that a visualization effect of the battery analysis result can be improved. In addition, an index range of the battery health index provided in this embodiment of this application may be preconfigured, so that usage experience of the user can be improved.

In a possible design, the battery analysis result further includes prediction information, and the prediction information indicates a predicted battery state of health obtained based on the target battery management strategy.

In this design, the battery state of health obtained through prediction after the target battery management strategy is applied is displayed to the user, so that the user can choose whether to apply the target battery management strategy. In this way, selectability of the target battery management strategy can be provided for the user, so that requirements of more application scenarios can be met, and user experience can be improved.

In this design, this embodiment of this application may provide a plurality of scenarios in which the battery health report may be displayed to the user. The battery health report may be displayed to the user in response to a user operation, or may be automatically displayed to the user after the device detects a preset condition, or the like. In this way, timeliness of battery management can be improved, and a battery service life can be extended.

In a possible design, the method further includes: detecting a third operation on first information included in the battery state of health information, where the first information indicates one of the battery health index, the aging rate information, the interpretation information of the battery state of health, or the target battery management strategy, and indicates preset preview information; and displaying a second interface in response to the third operation, where the second interface indicates information content related to the preview information of the first information.

In this design, the device may display various battery analysis results on the first interface in a preview form, and jump to an interface for displaying detailed information in response to an operation of tapping the preview information by the user. In this way, a display effect on the first interface can be improved, and operation complexity of viewing the first interface by the user can be reduced.

In a possible design, the battery analysis result includes but is not limited to one or more of a battery analysis result of the first device, a battery analysis result of a second device, and battery analysis results of a plurality of devices.

In this design, the first device may display the battery state of health of the first device, or may display a battery state of health of another device. For example, the another device may be an energy storage battery or a vehicle battery. This is not limited in this application. In this way, in this embodiment of this application, a scenario in which a battery management status of the target device can be conveniently viewed can be provided for the user, so that usage experience of the user can be improved.

In a possible design, when the battery analysis result includes the battery analysis results of the plurality of devices, the first interface further includes but is not limited to one or more of the following information: distribution information of the battery analysis results of the plurality of devices; and ranking information of the battery analysis results of the plurality of devices.

In some possible embodiments, the distribution information of the battery state of health may include but is not limited to: distribution information based on a feature of at least one user profile, distribution information based on a feature of at least one environment profile, distribution information based on a feature of at least one battery profile, distribution information based on a feature of at least one device profile, distribution information based on a feature of at least one type of power generation profile data; distribution information based on a feature of at least one type of power grid profile data, distribution information based on a feature of at least one type of carbon footprint profile data, and distribution information based on a feature of at least one type of production profile data. For example, the device is a vehicle. A feature of a vehicle profile may include but is not limited to a travel mileage, a vehicle speed, an acceleration, long-distance travel, travel time (for example, travel on a workday or travel on a weekend), charging time (in a non-full-charged state), a charging temperature, and a full-charged state.

In some other embodiments, the ranking information of the battery state of health may indicate degrees of impact of various features on battery health. For example, the ranking information may be displayed in a form of two-dimensional coordinates. A horizontal coordinate may indicate a level of impact of a feature value of a feature. A larger horizontal coordinate corresponding to a feature value may indicate greater positive impact on battery health. On the contrary, a smaller horizontal coordinate corresponding to a feature value may indicate greater negative impact on battery health. A larger vertical coordinate (a higher ranking) of a feature may indicate greater impact of the feature on battery health, and a smaller vertical coordinate of the feature may indicate smaller impact of the feature on battery health. It may be understood that impact on battery health of the device may be displayed based on the distribution information and the ranking information, so that the user can understand a reason for battery health attenuation, and the user can perform accurate battery management, to extend battery service life.

In this design, the first interface may further display battery analysis results of devices on an entire network, and may further perform statistical analysis on the battery analysis results of the devices on the entire network. In this way, a back-end server or a back-end technician can perform more accurate and timely battery management.

In a possible design, the method further includes: sending prompt information to at least one device based on the battery analysis results of the plurality of devices, where the at least one device is a device whose battery state of health meets a preset state of health, and the prompt information indicates the battery state of health corresponding to the device.

In this design, based on that the battery analysis results of the plurality of devices on the entire network may be obtained, the prompt information may be sent, based on distribution of battery states of health of the plurality of devices, to a device on which battery management needs to be performed. In this way, the user can be notified in time that battery management needs to be performed on the device, so that a battery service life can be extended.

In a possible design, before the displaying the first interface, the method further includes: receiving battery state of health data from a server; and obtaining the battery analysis result based on the battery state of health data.

In this design, the battery analysis result displayed by the first device may be obtained based on the battery health data sent by the server. Based on a computing capability of the server, the server can implement more accurate battery state of health analysis, and the server may further obtain battery state of health data of the first device with reference to the battery states of health of the devices on the entire network, so that accuracy of battery management of the device can be improved.

In a possible design, before receiving the battery state of health data from the server, the method further includes: collecting data of the first device, where the battery data includes battery usage data and usage data of the user for the first device; and sending the battery data to the server.

In this design, based on a scenario in which the server analyzes the battery state of health of the device, the first device may send the collected battery data to the server, so that battery management efficiency of the device can be improved based on a high computing capability of the server.

In a possible design, the first device is used in a vehicle including a battery, and the battery analysis result indicates an analysis result of the battery of the vehicle; or the first device is used in an energy storage device including an energy storage battery, and the battery analysis result is an analysis result of the energy storage battery; or the first device is a mobile phone, a tablet computer, or a notebook computer, and the battery analysis result is an analysis result of the energy storage battery.

In a possible design, the method further includes: collection user feedback data on the first interface, where the user feedback data indicates a user behavior related to the battery analysis result; and/or collecting device feedback data on the first interface, where the device feedback data indicates device collection information related to the battery analysis result.

In a possible design, the method further includes: when the battery analysis result includes the target battery management strategy, managing a battery of the first device based on the target battery management strategy.

In a possible design, when the battery analysis result includes the target battery management strategy, the method further includes: detecting a first operation, where the first operation indicates to apply the target battery management strategy, the first operation includes a user operation on a first control or detecting that the first device meets a first preset condition, and the first preset condition includes that the first device obtains an updated target battery management strategy, or the first device detects at least one of a preset application moment or a preset application condition; and downloading and applying the target battery management strategy in response to the first operation.

In this design, this embodiment of this application may provide a plurality of possible implementations of applying the target battery management strategy. The target battery management strategy may be applied in response to a user operation, or may be automatically applied after the device detects a preset event. In this way, more application scenarios can be met, and usage experience of the user can be improved.

In a possible design, the first operation includes but is not limited to a user operation on a second control, where the second control indicates to display the battery analysis result. When it is detected that the first device meets a second preset condition, the second preset condition includes one or more of the following conditions: a preset temperature state, preset time, a preset use state, and a preset state of health.

In a possible design, the method further includes: detecting a second operation on first information included in the battery analysis result on the first interface, where the first information indicates preview information of the battery health index of the device, preview information of the first aging rate, preview information of the interpretation information of the battery state of health, or preview information of the target battery management strategy; and displaying a fifth interface in response to the second operation, where the fifth interface indicates detailed information corresponding to the first information.

In a possible design, the method further includes: detecting a fourth operation on the composition of the battery health index of the device; and displaying a sixth interface in response to the fourth operation, where the sixth interface indicates interpretation information of the composition of the battery health index of the device.

Based on the foregoing possible designs, the battery analysis result includes at least one of the following battery types: electrochemical cell, battery module, battery pack, or battery cluster.

According to a third aspect, an embodiment of this application further provides a battery management method, and the method may be applied to a server. In the method, the server receives battery data sent by M devices, where M is a positive integer, and the battery data includes but is not limited to battery usage data and usage data of a user for a first device, analyzes M groups of battery data, generates battery state of health data of the first device, and/or generates battery state of health data of the M devices, where the battery state of health data is used to generate a battery analysis result. The battery analysis result includes but is not limited to one or more of the following information: a battery health index of a device, where different battery health indexes reflect different battery states of health; aging rate information, indicating an attenuation speed of battery health; interpretation information of a battery state of health, indicating a user behavior factor that affects the battery state of health; and a target battery management strategy, used to update a first aging rate to a second aging rate, where the second aging rate is less than the first aging rate.

In some possible designs, the first data includes data of the first device, and the data of the first device includes at least one of the following data content: battery physical data collected by the first device; first user behavior data that is collected by the first device on a first interface and that is related to battery management performed by the first device; second user behavior data that is collected by a second device on a second interface and that is related to battery management performed by the first device, where the second interface is used to display the battery analysis result of the first device; third user behavior data that is collected by a third device on a third interface and that is related to battery management performed by the first device, where the third interface is used to display the battery analysis results of the M devices; and fourth user behavior data that is obtained by the server through analysis and that is related to battery management performed by the first device.

In some possible designs, the server may further have a data collection and analysis function, including but not limited to: data structure display and analysis, collection frequency display and analysis, output frequency display and analysis, cost calculation display and analysis, cost optimization display and analysis, and the like. An analysis function that can be performed by the server is not limited in this application.

In a possible design, analyzing the M groups of battery data includes: performing analysis based on the battery data to obtain one or more of battery specific capacity data, battery voltage data, battery resistance data, battery discrete data, user profile data, environment profile data, battery profile data, device profile data, power generation profile data, power grid profile data, carbon footprint profile data, production profile data, and the like. The user profile data, the environment profile data, the battery profile data, and the device profile data are concerned features in the field of vehicle-mounted and 3C electronic products (such as a mobile phone, a tablet, and a notebook computer). The user profile data, the environment profile data, the battery profile data, the device profile data, the power generation profile data, the power grid profile data, the carbon footprint profile data, and the production profile data are concerned features in the energy storage field (such as a user scenario, a commercial and industrial industry scenario, a utility-scale scenario, a data center scenario, and a site energy scenario).

In a possible design, the server may generate the target battery management strategy of the first device based on the user profile data. This may be implemented as follows: The server generates at least one battery management strategy in at least one preset manner, and determines the target battery management strategy from the at least one battery management strategy based on the user profile data. In this way, the server may select, for the user, a battery management strategy that can better match a preference of the user, so that user experience can be improved.

For example, generating the at least one battery management strategy in the at least one preset manner may include but is not limited to the following manners:

Manner A: In a possible design, generating the battery management strategy of the first device based on the battery state of health data includes: clustering or classifying the M devices based on the M groups of battery data; determining N devices that belong to a same cluster or category as the first device, where N is a positive integer; determining, from the N devices, a target device whose battery analysis result meets a preset condition, where the preset condition may be, for example, a device with a similar condition like an environment and a temperature, and for example, a device whose user is a taxi driver may preferentially be selected as the target device if a user of the first device is a taxi driver; and generating the battery management strategy of the first device based on the battery management strategy of the target device. In this design, after clustering or classifying the devices on the entire network, the server may generate the battery management strategy of the first device based on a clustering result or a classification result, to obtain a more accurate battery management strategy. In some embodiments, the type of device that belongs to a same cluster or category as the first device is determined based on but not limited to one or more of the following information: user profile data, environment profile data, battery profile data, device profile data, power generation profile data, power grid profile data, carbon footprint profile data, and a production profile. The user profile data, the environment profile data, the battery profile data, and the device profile data are concerned features in the field of vehicle-mounted and 3C electronic products (such as a mobile phone, a tablet, and a notebook computer). The user profile data, the environment profile data, the battery profile data, the device profile data, the power generation profile data, the power grid profile data, the carbon footprint profile data, and the production profile are concerned features in the energy storage field (such as a user scenario, a commercial and industrial industry scenario, a utility-scale scenario, a data center scenario, and a site energy scenario).

In some embodiments, generating the battery management strategy of the first device based on the battery management strategy of the target device may be implemented as using the battery management strategy of the target device as the battery management strategy of the first device.

Manner B: In some other embodiments, after the N devices that belong to the same cluster or category as the first device are determined, and the target device whose battery analysis result meets the preset condition is determined from the N devices, generating the battery management strategy of the first device based on the battery management strategy of the target device may alternatively be implemented as adaptively generating or adjusting the battery management strategy of the first device based on the battery management strategy of the target device. In this way, the server may obtain a locally optimal battery management strategy based on battery data of a plurality of devices similar to the first device, and may further improve matching with the first device.

Manner C: In another possible design, generating the battery management strategy of the first device based on the battery state of health data includes: generating a globally optimal usage strategy based on the M groups of battery data, and then generating the battery management strategy of the first device based on a clustering condition or a classification condition and an optimization strategy knowledge graph. Alternatively, the globally optimal usage strategy may be directly used as the battery management strategy of the first device. In this design, the server may perform statistical analysis on the devices on the entire network, or may generate the battery management strategy of the first device based on battery data of the devices on the entire network, to obtain the battery management strategy obtained from more perspectives.

In some possible embodiments, after the battery management strategy of the at least one first device is obtained in one or more of Manner A to Manner C, determining the target battery management strategy from the at least one battery management strategy of the first device may be implemented as analyzing a user preference based on the user profile data, where the user preference includes but is not limited to: a preference of the user for battery usage, a preference for a customized battery strategy, an acceptance degree of a new thing, a preference for device usage, and the like.

In addition, in some other possible embodiments, the user profile data may alternatively be updated in real time, and a composition source includes but is not limited to original cloud data and user feedback data. For example, the server receives at least one of user feedback data and device feedback data that are sent by the M devices, where the user feedback data indicates a user feedback behavior related to the battery analysis result, and the device feedback data indicates device collection information related to the battery analysis result, updates the user profile data based on at least one of the user feedback data and the device feedback data, and updates and determines the target battery management strategy from the at least one battery management strategy based on updated user profile data.

A data source of the user feedback data may include but is not limited to user end data and remote after-sales end data. The user end data may originate from a strategy interaction feedback, including but not limited to: stay time of the user on a corresponding interface, a status of enabling an optimization strategy switch by a user, a status of degrading/withdrawing an optimization strategy by a user, feedback information (including but not limited to a text and a voice) output by a user at an interaction entry like "I have something to say" or any location on an interface, or information (including but not limited to a text, a voice, a scrolling comment, a picture, and a video) published, liked, added to favorites, or reprinted in a corresponding community module. The remote after-sales end data may originate from, including but not limited to, a manual customer service feedback module (including but not limited to a phone call, a text message, an email, an after-sales record, and the like), information (including but not limited to a text, a voice, and the like) output by an interaction entry at any location on an interface; information (including but not limited to a text, a voice, a scrolling comment, a picture, and a video) posted, liked, added to favorites, or reprinted by a user in the corresponding community module, analysis of a user's historical stay duration on a corresponding interface, analysis of a user's historical feedback on a battery health strategy, analysis of a user's historical acceptance of a battery optimization strategy, analysis of a user's behavior change after the user accepts a strategy, and a knowledge graph of a user profile and strategy optimization.

In a possible design, the battery health index includes but is not limited to at least one of the following indexes: a battery health index of the battery, a capacity-type battery health index, a voltage-type battery health index, a resistance-type battery health index, and a discrete-type battery health index. The capacity-type battery health index may include but is not limited to: a maximum battery capacity; or a ratio of a maximum battery capacity to a corresponding nominal capacity, which may also be referred to as a battery state of health (state of health, SOH).

In a possible design, the method further includes: sending the battery state of health data of the first device to the first device; or sending the battery state of health data of the first device to the second device; or sending the battery state of health data of the M devices to the first device or the second device.

In a possible design, the battery analysis results of the M devices include but are not limited to one or more of the following information: distribution information of the battery analysis results of the plurality of devices; and ranking information of the battery analysis results of the plurality of devices. In some possible embodiments, the distribution information of the battery state of health may include but is not limited to: distribution information based on a feature of at least one user profile, distribution information based on a feature of at least one environment profile, distribution information based on a feature of at least one battery profile, distribution information based on a feature of at least one device profile, distribution information based on a feature of at least one type of power generation profile data; distribution information based on a feature of at least one type of power grid profile data, distribution information based on a feature of at least one type of carbon footprint profile data, and distribution information based on a feature of at least one type of production profile data. For example, the device is a vehicle. A feature of a vehicle profile may include but is not limited to a travel mileage, a vehicle speed, an acceleration, long-distance travel, travel time (for example, travel on a workday or travel on a weekend), charging time, a charging temperature, and a full-charged state. In some other embodiments, the ranking information of the battery state of health may indicate degrees of impact of various features on battery health. For example, the ranking information may be displayed in a form of two-dimensional coordinates. A horizontal coordinate may indicate a level of impact of a feature value of a feature. A larger horizontal coordinate may indicate greater impact, and a smaller horizontal coordinate indicates smaller impact. A larger vertical coordinate (a higher ranking) of a feature may indicate greater impact of the feature on battery health, and a smaller vertical coordinate of the feature may indicate smaller impact of the feature on battery health. It may be understood that impact on battery health of the device may be displayed based on the distribution information and the ranking information, so that the user can understand a reason for battery health attenuation, and the user can perform accurate battery management, to extend battery service life.

In a possible design, prompt information is sent to at least one device based on the battery analysis results of the M devices, where the at least one device is a device whose battery state of health meets a preset state of health, and the prompt information indicates the battery state of health corresponding to the device.

In a possible design, the ranking information includes but is not limited to one or a combination of first indication information and second indication information, where the first indication information indicates a degree of urgency of intervention in battery health, and the second indication information indicates an order of intervention in battery health.

In a possible design, the distribution information or the ranking information is represented by using, but not limited to, one or more of a coordinate graph, a list, or a text form.

Based on the foregoing possible designs, the battery analysis result includes at least one of the following battery types: electrochemical cell, battery module, battery pack, or battery cluster.

According to a fourth aspect, an embodiment of this application further provides a battery management apparatus. The battery management apparatus includes modules/units for performing the method according to any one of the possible designs of the second aspect. These modules/units may be implemented by hardware, or may be implemented by executing corresponding software by hardware.

In some possible embodiments, the battery management apparatus may include a processing module and a display module. The processing module is configured to detect a first operation, where the first operation is used to display a battery analysis result. The processing module is further configured to obtain display data of a first interface in response to the first operation. The display module is configured to display the first interface, where the first interface includes the battery analysis result. The battery analysis result includes but is not limited to one or more of the following information: a battery health index of a device, where different battery health indexes reflect different battery states of health; aging rate information, indicating an attenuation speed of battery health; interpretation information of a battery state of health, indicating a user behavior factor that affects the battery state of health; a target battery management strategy, used to update a first aging rate to a second aging rate, where the second aging rate is less than the first aging rate; and composition of the battery health index of the device, where the composition includes at least one of a capacity-type battery health index, a voltage-type battery health index, a resistance-type battery health index, and a discrete-type battery health index.

According to a fifth aspect, an embodiment of this application further provides an electronic device, where the electronic device includes at least one memory and at least one processor. The at least one memory is configured to store computer program code, and the computer program code includes computer instructions. When the computer instructions are executed by the at least one processor, the electronic device is enabled to perform the method according to any one of the possible designs of the second aspect. In some embodiments, the electronic device may further include a battery, and the method according to any one of the possible designs of the second aspect is used to perform battery management on the battery included in the electronic device. In some other embodiments, when performing the method according to any one of the possible designs of the second aspect, the electronic device may be further configured to display a battery state of health included in another device, so that a user performs battery management on the another device timely.

According to a sixth aspect, an embodiment of this application further provides a battery management apparatus. The battery management apparatus includes modules/units for performing the method according to any one of the possible designs of the third aspect. These modules/units may be implemented by hardware, or may be implemented by executing corresponding software by hardware.

In some possible embodiments, the battery management apparatus may include a communication module and a processing module. The communication module is configured to receive battery data sent by M devices, where M is a positive integer, and the battery data includes battery usage data and usage data of a user for a first device. The processing module is configured to analyze M groups of battery data. The processing module is further configured to generate battery state of health data of the first device, and/or generate battery state of health data of the M devices, where the battery state of health data is used to generate a battery analysis result. The battery analysis result includes but is not limited to one or more of the following information: a battery health index of a device, where different battery health indexes reflect different battery states of health; aging rate information, indicating an attenuation speed of battery health; interpretation information of a battery state of health, indicating a user behavior factor that affects the battery state of health; a target battery management strategy, used to update a first aging rate to a second aging rate, where the second aging rate is less than the first aging rate; and composition of the battery health index of the device, where the composition includes at least one of a capacity-type battery health index, a voltage-type battery health index, a resistance-type battery health index, and a discrete-type battery health index.

According to a seventh aspect, an embodiment of this application further provides a server, where the server includes at least one memory and at least one processor. The at least one memory is configured to store computer program code, and the computer program code includes computer instructions. When the computer instructions are executed by the at least one processor, the server is enabled to perform the method according to any one of the possible designs of the third aspect.

According to an eighth aspect, a computer-readable storage medium is provided, where the computer-readable medium stores a computer program (which may also be referred to as code or instructions). When the code or the instructions are run on a computer, the computer is enabled to perform the method according to any one of the possible designs of the second aspect or perform the method according to any one of the possible designs of the third aspect.

According to a ninth aspect, a computer program product is provided. The computer program product includes a computer program (which may also be referred to as code or instructions). When the computer program is run, the method according to any one of the possible designs of the second aspect is performed, or the method according to any one of the possible designs of the third aspect is performed.

According to a tenth aspect, a graphical user interface on a device is further provided. The device has a display, one or more memories, and one or more processors. The one or more processors are configured to execute one or more computer programs stored in the one or more memories, the graphical user interface includes a graphical user interface displayed when the device performs any one of the possible designs of the second aspect in embodiments of this application.

It should be noted that, for beneficial effects of the designs provided in the first aspect and the third aspect to the tenth aspect of embodiments of this application, refer to beneficial effects of any one of the possible designs of the second aspect. Details are not described herein again.

### BRIEF DESCRIPTION OF DRAWINGS

FIG. 1 is a diagram of a display interface of a device;
FIG. 2a is a diagram of a scenario to which an embodiment of this application is applicable;
FIG. 2b is a diagram of a structure of a device according to an embodiment of this application;
FIG. 3 is a diagram of a software architecture of a device according to an embodiment of this application;
FIG. 4A to FIG. 4D are interface diagrams 1 of a battery management method according to an embodiment of this application;
FIG. 5a is a diagram of a battery health index according to an embodiment of this application;
FIG. 5b is a diagram of proportional relationships between various types of battery health indexes according to an embodiment of this application;
FIG. 6 is a diagram of aging rate information of a battery health index according to an embodiment of this application;
FIG. 7 is a time trend diagram of a battery health index in a battery management method according to an embodiment of this application;
FIG. 8a(1) and FIG. 8a(2) are interface diagrams 2 of a battery management method according to an embodiment of this application;
FIG. 8b(1) to FIG. 8b(3) are interface diagrams 3 of a battery management method according to an embodiment of this application;
FIG. 8c is an interface diagram 4 of a battery management method according to an embodiment of this application;
FIG. 9 is an interface diagram 5 of a battery management method according to an embodiment of this application;
FIG. 10 is an interface diagram 6 of a battery management method according to an embodiment of this application;
FIG. 11a is an interface diagram 7 of a battery management method according to an embodiment of this application;
FIG. 11b is an interface diagram 8 of a battery management method according to an embodiment of this application;
FIG. 11c is an interface diagram 9 of a battery management method according to an embodiment of this application;
FIG. 12a is an interface diagram 10 of a battery management method according to an embodiment of this application;
FIG. 12b is an interface diagram 11 of a battery management method according to an embodiment of this application;
FIG. 13 is an interface diagram 12 of a battery management method according to an embodiment of this application;
FIG. 14 is a diagram of a scenario of a battery management method according to an embodiment of this application; and
FIG. 15 is a schematic flowchart of a battery management method according to an embodiment of this application.

### DESCRIPTION OF EMBODIMENTS

The following describes in detail embodiments of this application with reference to accompanying drawings.

A battery management method provided in embodiments of this application is applicable to a device. For example, the device may be various devices equipped with a battery. Alternatively, the device may be a device having a display function, and may display a battery analysis result of another device. With explosive growth of batteries and wide application in the fields of new energy vehicles, energy storage, and 3C electronic products (a general term of computer, communication, and consumer electronic products), battery issues such as battery safety and a service life deserve increasing attention.

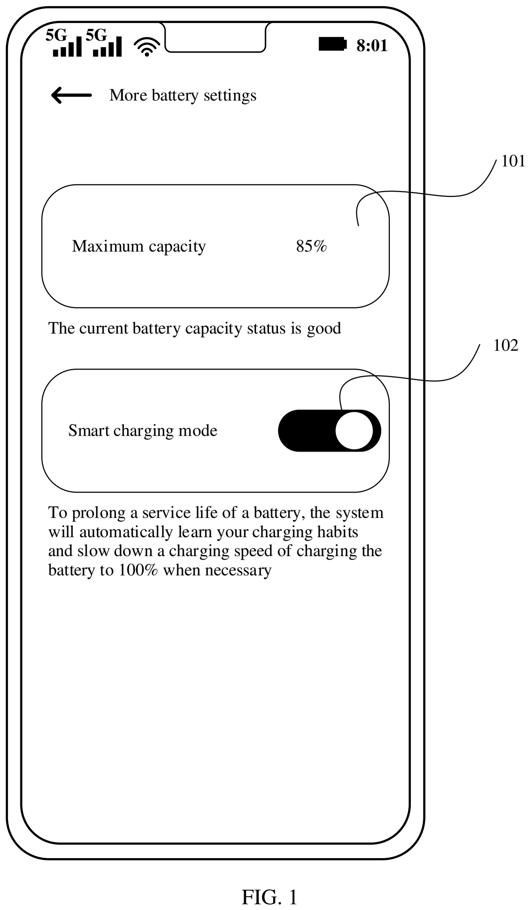

Because different users have different usage habits, charging habits, and the like of devices, battery states of health of different devices are different. Especially in some scenarios, batteries may experience extreme problems such as thermal runaway. Currently, a large quantity of batteries unpredictably experience extreme problems. As a result, a security risk cannot be completely eliminated. In addition, current battery management is mostly for a battery in which a fault occurs or a battery capacity status is poor. For example, FIG. 1 is a diagram of a display interface of a device. It can be learned from FIG. 1 that currently, the device may generally provide a maximum capacity 101 and a smart charging mode control 102. The maximum capacity 101 is an actual capacity based on a current state of a battery. Usually, as the actual capacity of the battery changes, a percentage value displayed by the maximum capacity 101 gradually decreases from 100%. The maximum capacity 101 may be used as a reference for a user to consider whether to replace the battery. For example, when the maximum capacity 101 is less than 80%, the user can replace the battery with a new one. Currently, the smart charging mode control 102 may be provided by a large quantity of devices to perform adaptive battery charging management based on a charging habit of a user, so that a battery service life can be effectively extended by reducing duration in which the battery is in a full-charged state. However, in current battery management, statistics are collected only from a maximum capacity of a battery and battery charging management is performed based on a charging habit of a user. This has specific limitations on extending a battery service life and using the battery healthily.

In view of this, an embodiment of this application provides a battery management method. In the method, a new technical solution for battery management is provided, a new evaluation index of a battery state of health can be provided, and a targeted analysis report based on an evaluation index can be generated. This helps a user perform battery management on the battery as soon as possible. In addition, in the method, strategies corresponding to different devices may be further generated for the different devices. This helps perform targeted battery management, to better extend a battery service life.

It may be understood that, in this embodiment of this application, the device equipped with a battery may be a device like a new energy vehicle or an energy storage battery, or may be a consumer device like a mobile phone, a wearable device (for example, a band, a watch, a helmet, or a foot ring), an augmented reality (augmented reality, AR)/virtual reality (virtual reality, VR) device, a tablet computer, a notebook computer, an ultra-mobile personal computer (ultra-mobile personal computer, UMPC), a netbook, a smart home device (for example, a smart television, a smart screen, or a smart speaker), or a personal digital assistant (personal digital assistant, PDA). It may be understood that a specific type of a device equipped with a battery is not limited in embodiments of this application.

In addition, the battery equipped in the device described in embodiments of this application may be but is not limited to a lithium-ion battery, a sodium-ion battery, a lead-acid battery, a nickel-hydrogen battery, a nickel-cadmium battery, or the like. A specific type of the battery is not limited in this application. In addition, a specific material or the like used by the battery is also not limited in embodiments of this application.

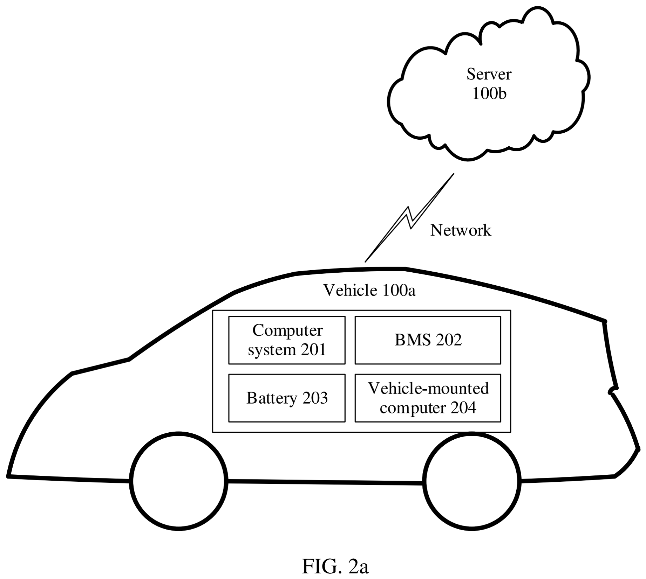

For ease of understanding, an example in which the device is a vehicle including a computer is used. FIG. 2a is a diagram of an application scenario to which an embodiment of this application is applicable. In this application scenario, a vehicle 100a and a server 100b may be included, and the vehicle 100a and the server 100b may communicate with each other through a network. The vehicle 100a may include but is not limited to a computer system 201, a battery management system (battery management system, BMS) 202, a battery 203, and a vehicle-mounted computer 204. It may be understood that communication between the vehicle 100a and the server 100b may be implemented as communication with the server through the vehicle-mounted computer 204.

Some or all of functions of the vehicle 100a are controlled by the computer system 201. Although not shown in FIG. 2a, the computer system 201 may include at least one processor, and the processor executes instructions stored in a non-transient computer-readable medium such as a memory. The computer system may alternatively be a plurality of computing devices that control individual components or subsystems of the vehicle 100a in a distributed manner. The processor may be any conventional processor, for example, a central processing unit (central processing unit, CPU). Alternatively, the processor may further include, for example, a graphics processing unit (graphics processing unit, GPU), a field programmable gate array (field programmable gate array, FPGA), a system on a chip (system on a chip, SOC), an application-specific integrated circuit (application-specific integrated circuit, ASIC), or a combination thereof. In addition to the instructions, the memory may further store data, such as a road map, route information, a location, a direction, a speed, and other such vehicle data of a vehicle, and other information. Such information may be used by the vehicle 100a and the computer system 201 when the vehicle 100a operates in an autonomous mode, a semi-autonomous mode, and/or a manual mode. It should be understood that the structure of the vehicle in FIG. 2a should not be understood as a limitation on embodiments of this application.

The BMS 202 may be configured to manage functions such as charging, discharging, and power consumption of the battery 203. In this embodiment of this application, the BMS 202 may perform management based on a management strategy configured before delivery. After receiving a battery management strategy from the server 100b, the vehicle 100a may further perform battery management with reference to a battery management strategy from a cloud.

The vehicle-mounted computer 204 may be configured to display a battery analysis result obtained by the server 100b, and may further receive strategy interaction and strategy feedback of a user on the vehicle-mounted computer 204, to comprehensively and accurately analyze the battery state of health.

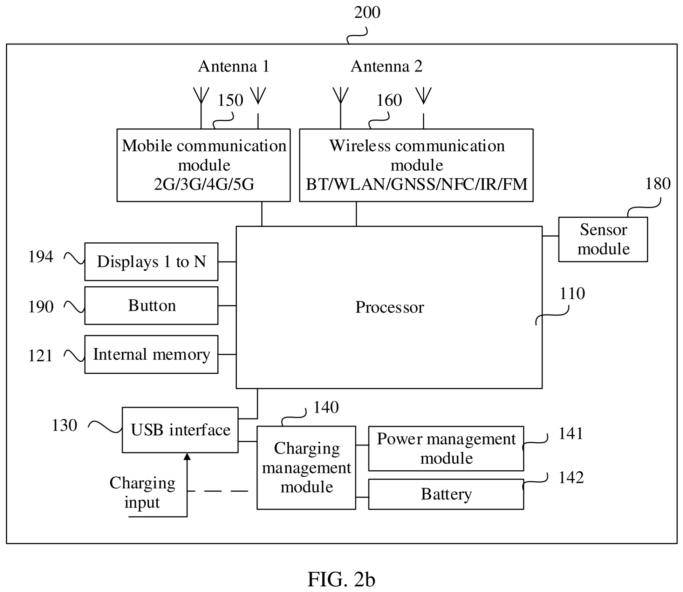

For ease of understanding, an example in which the device is a mobile phone is used. FIG. 2b is a diagram of a structure of a device 200 to which a technical solution of this application is applied. In addition, the battery analysis result of the vehicle may be displayed on the vehicle-mounted computer 204 shown in FIG. 2a, or may be displayed on the mobile phone, so that the user can conveniently view the battery analysis result of the vehicle.

As shown in FIG. 2b, the device 200 may include a processor 110, an internal memory 121, a universal serial bus (universal serial bus, USB) interface 130, a charging management module 140, a power management module 141, a battery 142, an antenna 1, an antenna 2, a mobile communication module 150, a wireless communication module 160, a sensor module 180, a button 190, a display 194, and the like.

The processor 110 may include one or more processing units. For example, the processor 110 may include an application processor (application processor, AP), a modem processor, a graphics processing unit (graphics processing unit, GPU), an image signal processor (image signal processor, ISP), a controller, a memory, a video codec, a digital signal processor (digital signal processor, DSP), a baseband processor, and/or a neural-network processing unit (neural-network processing unit, NPU). Different processing units may be independent components, or may be integrated into one or more processors. The controller may be a nerve center and a command center of the device 200. The controller may generate an operation control signal based on instruction operation code and a time sequence signal, to complete control of instruction fetching and instruction execution. A memory may be further disposed in the processor 110, and is configured to store instructions and data. In some embodiments, the memory in the processor 110 is a cache memory. The memory may store instructions or data just used or cyclically used by the processor 110. If the processor 110 needs to use the instructions or the data again, the processor 110 may directly invoke the instructions or the data from the memory. This may avoid repeated access, and reduce waiting time of the processor 110, to improve system efficiency.

In some embodiments, the processor 110 may include one or more interfaces. The interfaces may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, a universal serial bus (universal serial bus, USB) interface, and/or the like.

A wireless communication function of the device 200 may be implemented through the antenna 1, the antenna 2, the mobile communication module 150, the wireless communication module 160, the modem processor, the baseband processor, and the like. The antenna 1 and the antenna 2 are configured to transmit and receive an electromagnetic wave signal. Each antenna in the device 200 may be configured to cover one or more communication frequency bands. Different antennas may be further multiplexed, to improve antenna utilization. For example, the antenna 1 may be multiplexed as a diversity antenna of a wireless local area network. In some other embodiments, the antenna may be used in combination with a tuning switch.

The mobile communication module 150 may provide a wireless communication solution that is applied to the device 200 and that includes a 2G/3G/4G/5G or the like. The mobile communication module 150 may include at least one filter, a switch, a power amplifier, a low noise amplifier (low noise amplifier, LNA), and the like. The mobile communication module 150 may receive an electromagnetic wave through the antenna 1, perform processing such as filtering or amplification on the received electromagnetic wave, and transmit the electromagnetic wave to the modem processor for demodulation. The mobile communication module 150 may further amplify a signal modulated by the modem processor, and convert the signal into an electromagnetic wave for radiation through the antenna 1. In some embodiments, at least some functional modules in the mobile communication module 150 may be disposed in the processor 110. In some embodiments, at least some functional modules of the mobile communication module 150 may be disposed in a same device as at least some modules of the processor 110.

In this embodiment of this application, the device 200 may communicate with the cloud by using the mobile communication module 150. For example, the mobile phone may upload collected battery-related data to the cloud, and the cloud performs data analysis based on the battery-related data, to obtain a data analysis result. Then, the mobile phone may further receive the data analysis result from the cloud by using the mobile communication module 150, and display the data analysis result to the user in a preset form.

The wireless communication module 160 may provide a wireless communication solution that is applied to the device 200 and that includes a wireless local area network (wireless local area network, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), a near field communication (near field communication, NFC) technology, an infrared (infrared, IR) technology, or the like. The wireless communication module 160 may be one or more components integrating at least one communication processing module. The wireless communication module 160 receives an electromagnetic wave through the antenna 2, performs frequency modulation and filtering processing on an electromagnetic wave signal, and sends a processed signal to the processor 110. The wireless communication module 160 may further receive a to-be-transmitted signal from the processor 110, perform frequency modulation and amplification on the signal, and convert the signal into an electromagnetic wave for radiation through the antenna 2.

In some embodiments, in the device 200, the antenna 1 and the mobile communication module 150 are coupled, and the antenna 2 and the wireless communication module 160 are coupled, so that the device 200 can communicate with a network and another device by using a wireless communication technology.

The display 194 is configured to display a display interface of an application, and the like. The display 194 includes a display panel. In some embodiments, the device 200 may include one or N displays 194, where N is a positive integer greater than 1. For example, in this embodiment of this application, an evaluation index of a battery state of health (which may be referred to as a "battery health index" for short in the following embodiments), an interpretation report of the battery health index, composition of the battery health index, various types of battery health indexes, construction of various types of battery health indexes, and relationships between various types of battery health indexes and battery health indexes may be displayed to the user through the display 194. For example, when the device 200 is a new energy vehicle, the display 194 may be a display of a vehicle-mounted computer included in the new energy vehicle.

The internal memory 121 may be configured to store computer-executable program code. The executable program code includes instructions. The processor 110 runs the instructions stored in the internal memory 121, to perform various function applications of the device 200 and data processing. The internal memory 121 may include a program storage area and a data storage area. The program storage area may store an operating system, software code of at least one application, and the like. The data storage area may store data (for example, an image or a video) and the like generated in a process of using the device 200. In addition, the internal memory 121 may include a high-speed random access memory, or may include a nonvolatile memory, for example, at least one magnetic disk storage device, a flash storage device, or a universal flash storage.

The sensor module 180 may include, for example, but is not limited to, a touch sensor, a gravity sensor, and a pressure sensor. Details are not described in this application.

The button 190 may include a power button, a volume button, and the like. The button 190 may be a mechanical button, or may be a touch button. The device 200 may receive a button input, and generate a button signal input related to user setting and function control of the device 200.

The charging management module 140 may be configured to perform charging management based on a configured charging management strategy when the battery 142 included in the device 200 is being charged.

The power management module 141 may also be understood as a battery management system (battery management system, BMS), and may be configured to manage functions such as charging, discharging, and power consumption of the device 200. In this embodiment of this application, the power management module 141 may perform management based on a management strategy configured before delivery. After receiving the battery management strategy from the cloud, the device 200 may further perform battery management with reference to the battery management strategy from the cloud.

It may be understood that components shown in FIG. 2b do not constitute any specific limitation on the device 200. The device 200 in embodiments of this application may include more or fewer components than those shown in FIG. 2b. In addition, a combination/connection relationship between the components in FIG. 2b may also be adjusted and modified. For example, when the device 200 is a new energy vehicle, the device 200 may further include components such as an engine, a drive bridge, and wheels. For another example, when the device 200 is a mobile phone, the device 200 may further include components such as a camera and an audio module.

An operating system (operating system, OS) in embodiments of this application is most basic system software running on the device 200. A software system of the device 200 may use a layered architecture, an event-driven architecture, a microkernel architecture, a micro service architecture, or a cloud architecture. In this embodiment of this application, an operating system using a layered architecture is used as an example to describe a software system architecture of the device 200.

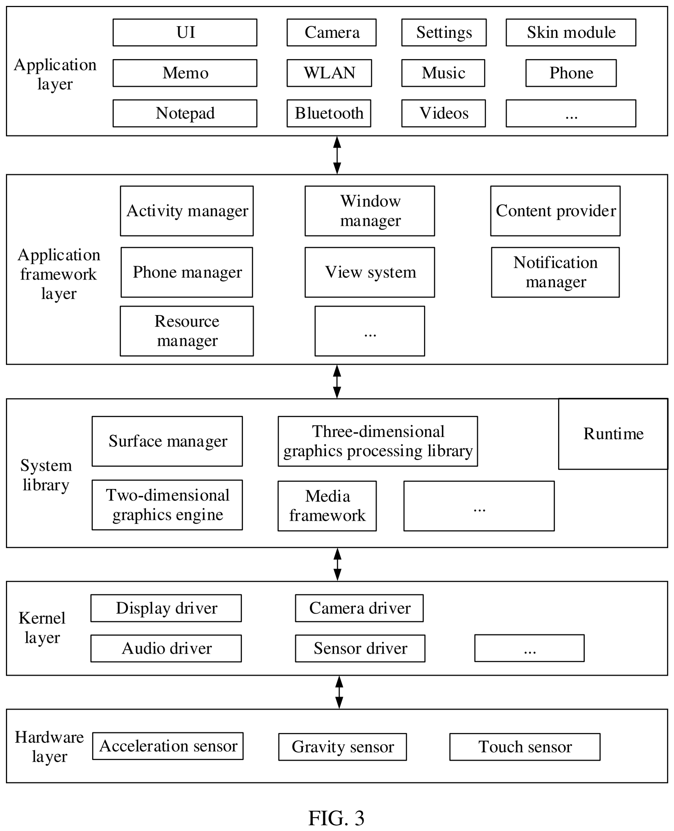

FIG. 3 is a block diagram of a software system architecture of a device 200 according to an embodiment of this application. As shown in FIG. 3, the software system structure of the device 200 may be a layered architecture. For example, software may be divided into several layers, and each layer has a clear role and task. The layers communicate with each other through a software interface. In some optional embodiments, for example, an operating system may be divided into five layers: an application layer, an application framework (framework, FWK) layer, a runtime and system library, a kernel layer, and a hardware layer from top to bottom.

The application layer may include a series of application packages. As shown in FIG. 3, the application layer may include an application (application, APP) like Camera, Settings, a skin module, a user interface (user interface, UI), and a third-party application. The third-party APP may include a wireless local area network (wireless local area network, WLAN), Music, Phone, Bluetooth, Videos, Memo, Notepad, and the like. In this embodiment of this application, the Settings APP at the application layer may be focused on. The Settings APP may include a related entry used to perform battery management. Alternatively, at the application layer, there may further be an application used to perform battery management, for example, may be referred to as "Battery safety guardian". In this way, a user may implement management on a battery such as battery management by using the "Settings" APP, the "Battery safety guardian" APP, and/or the like at the application layer.

In a possible implementation, an application may be developed by using a Java language, and is completed by invoking an application programming interface (application programming interface, API) provided by the application framework layer. A developer may interact with a bottom layer (for example, the hardware layer and the kernel layer) of the operating system through the application framework layer, to develop an application of the developer. The application framework layer mainly includes a series of services and management systems of the operating system.

The application framework layer provides an application programming interface and a programming framework for an application at the application layer. The application framework layer includes some predefined functions. As shown in FIG. 3, the application framework layer may include an activity manager, a window manager, a content provider, a view system, a phone manager, a resource manager, a notification manager, and the like.

The activity manager is configured to: manage a life cycle of each application, provide a common navigation rollback function, and provide an interaction interface for windows of all programs.

The window manager is configured to manage a window program. The window manager may obtain a size of the display, determine whether there is a status bar, perform screen locking, take a screenshot, and the like. The content provider is configured to store and obtain data, and enable the data to be accessed by an application. The data may include a video, an image, audio, calls that are made and received, a browsing history, a bookmark, a phone book, and the like.

The view system includes visual controls such as a control for displaying a text and a control for displaying an image. The view system may be configured to construct an application. A display interface may include one or more views. For example, a display interface including a text message notification icon may include a text display view and an image display view.

The phone manager is configured to provide a communication function of the device 200, for example, management of a call status (including answering, declining, or the like).

The resource manager provides various resources such as a localized character string, an icon, a picture, a layout file, and a video file for an application.

The notification manager enables an application to display notification information in a status bar, and may be configured to convey a notification message. The notification manager may automatically disappear after a short pause without a user interaction. For example, the notification manager is configured to notify download completion, give a message notification, and the like. The notification manager may alternatively be a notification that appears in a top status bar of the system in a form of a graph or a scroll bar text, for example, a notification of an application that is run on a background, or may be a notification that appears on the screen in a form of a dialog window. For example, text information is displayed in the status bar, an announcement is given, the device 200 vibrates, or the indicator light blinks.

The runtime includes a core library and a virtual machine. The runtime schedules and manages an operating system.

The kernel library includes two parts: a function that needs to be invoked in Java language, and a kernel library of the operating system. The application layer and the application framework layer run on the virtual machine. The virtual machine executes java files of the application layer and the application framework layer as binary files. The virtual machine is configured to implement functions such as object lifecycle management, stack management, thread management, security and exception management, and garbage collection.

The system library may include a plurality of functional modules, for example, a surface manager (surface manager), a media framework (media framework), a three-dimensional graphics processing library (for example, OpenGL ES), and a two-dimensional graphics engine (for example, SGL).

The surface manager is configured to: manage a display subsystem and provide fusion of 2D and 3D layers for a plurality of applications.

The media framework supports playback and recording of audio and videos in a plurality of commonly used formats, static image files, and the like. The media framework may support a plurality of audio and video coding formats such as MPEG-4, H.264, MP3, AAC, AMR, JPG, and PNG.

The three-dimensional graphics processing library is configured to implement three-dimensional graphics drawing, image rendering, composition, layer processing, and the like.

The two-dimensional graphics engine is a drawing engine for two-dimensional drawing.

In some embodiments, the three-dimensional graphics processing library may be configured to draw a three-dimensional motion trajectory image, and the two-dimensional graphics engine may be configured to draw a two-dimensional motion trajectory image. In this embodiment of this application, based on the data that is related to battery health and that is obtained by the device 200 or the cloud, an interface may be drawn based on the two-dimensional graphics engine or the three-dimensional image processing library, to display an interface related to battery management.

The kernel layer is a layer between hardware and software. The kernel layer includes at least a display driver, a camera driver, an audio driver, and a sensor driver.

The hardware layer may include various sensors such as an acceleration sensor, a gravity sensor, and a touch sensor.

Generally, the device 200 may simultaneously run a plurality of applications. In a simple case, one application may correspond to one process, and in a complex case, one application may correspond to a plurality of processes. Each process has a process number (process ID).

It should be understood that a hardware structure of the device 200 may be shown in FIG. 2b, and a software system architecture may be shown in FIG. 3. A software program and/or a module corresponding to the software system architecture of the device 200 may be stored in the internal memory 121, and the processor 110 may run the software program and the application stored in the internal memory 121, to perform a procedure of the battery management method provided in embodiments of this application.

In embodiments of this application, "at least one" means one or more, and "a plurality of" means two or more. In addition, it should be understood that, in descriptions of this specification, terms such as "first" and "second" are merely used for distinguishing and description, but should not be understood as indicating or implying relative importance, or should not be understood as indicating or implying a sequence. For example, a first device and a second device do not represent an importance degree of the first device and the second device or represent a sequence of the first device and the second device, and are merely used for distinguishing and description. A term "and/or" in embodiments of this application describes only an association relationship and represents that three relationships may exist. For example, A and/or B may represent the following three cases: Only A exists, both A and B exist, and only B exists. In addition, the character "/" in this specification generally indicates an "or" relationship between the associated objects.

Reference to "an embodiment", "some embodiments", or the like described in this specification means that specific features, structures, or characteristics described with reference to the embodiment are included in one or more embodiments of this specification. Therefore, statements such as "in an embodiment", "in some embodiments", "in some other embodiments", and "in other embodiments" that appear at different places in this specification do not necessarily mean reference to a same embodiment, instead, they mean "one or more but not all of embodiments", unless otherwise specifically emphasized. The terms "include", "have", and their variants all mean "include but are not limited to", unless otherwise specifically emphasized in another manner.

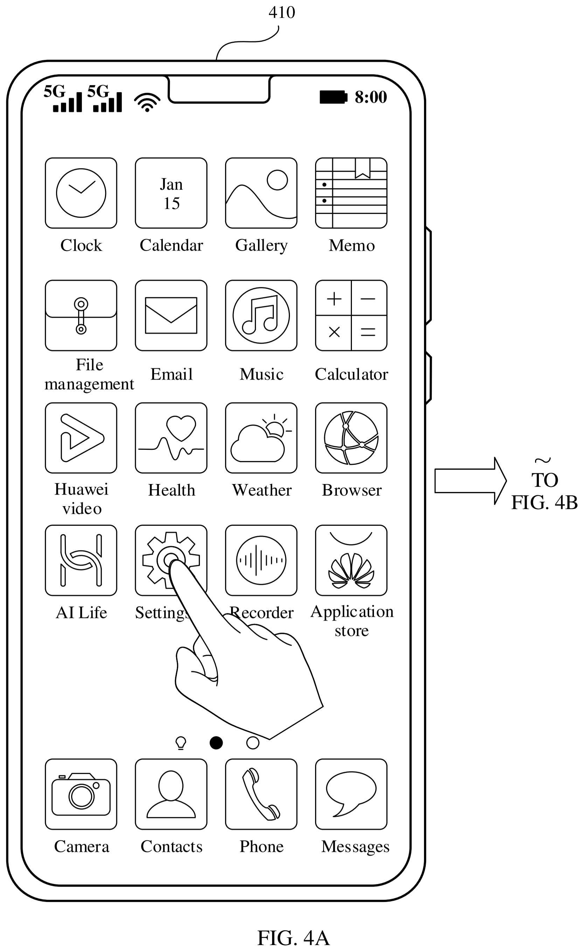

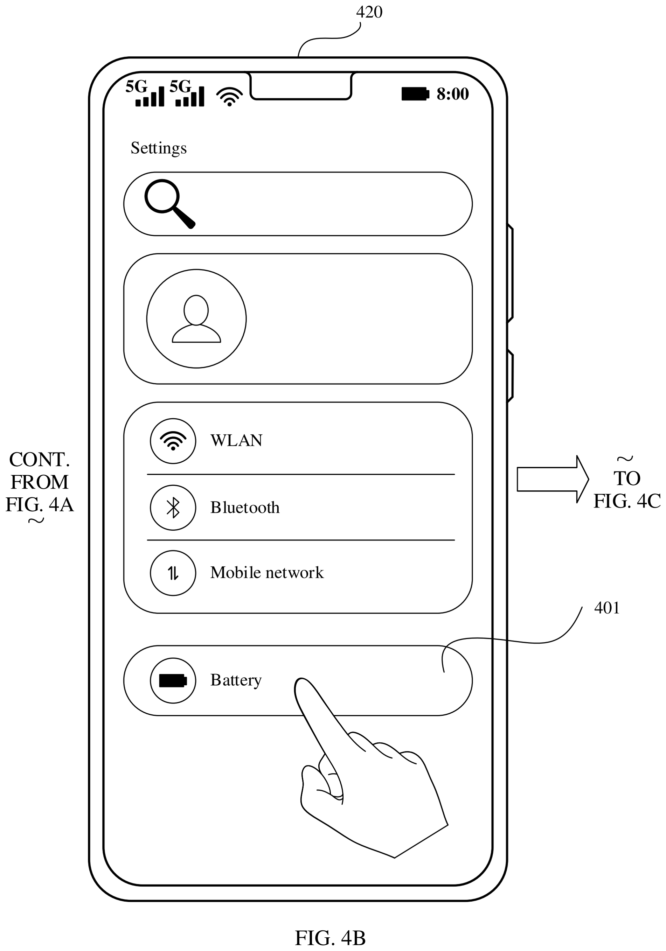

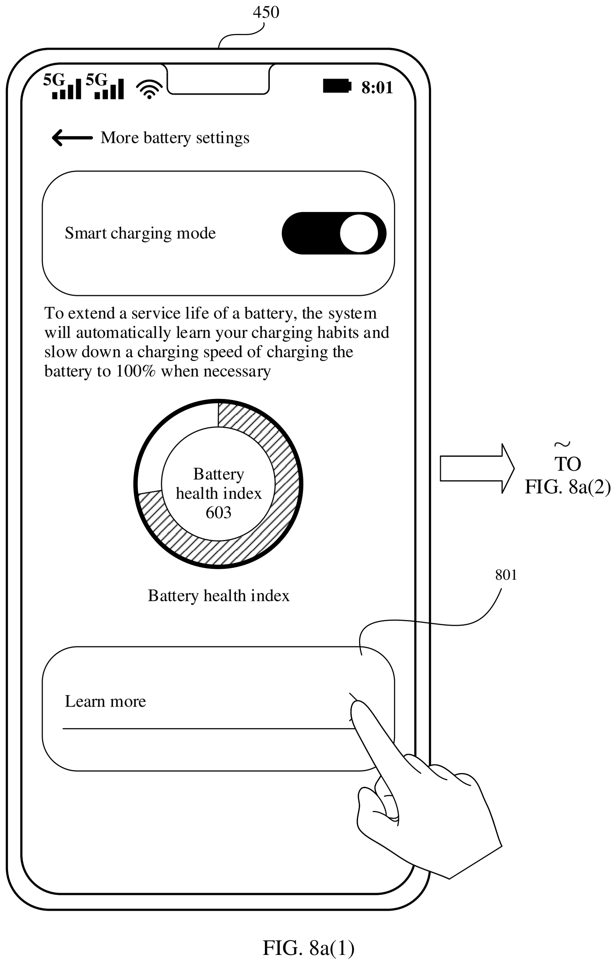

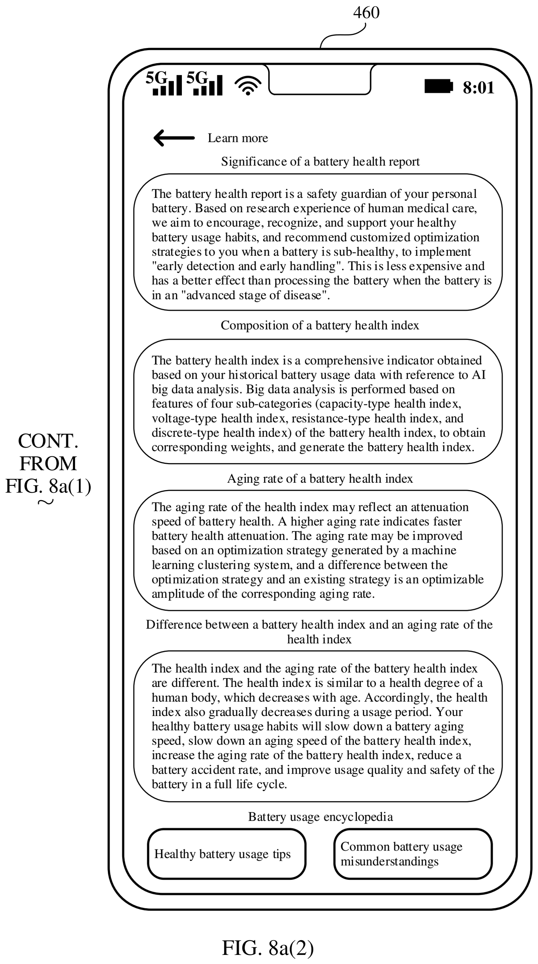

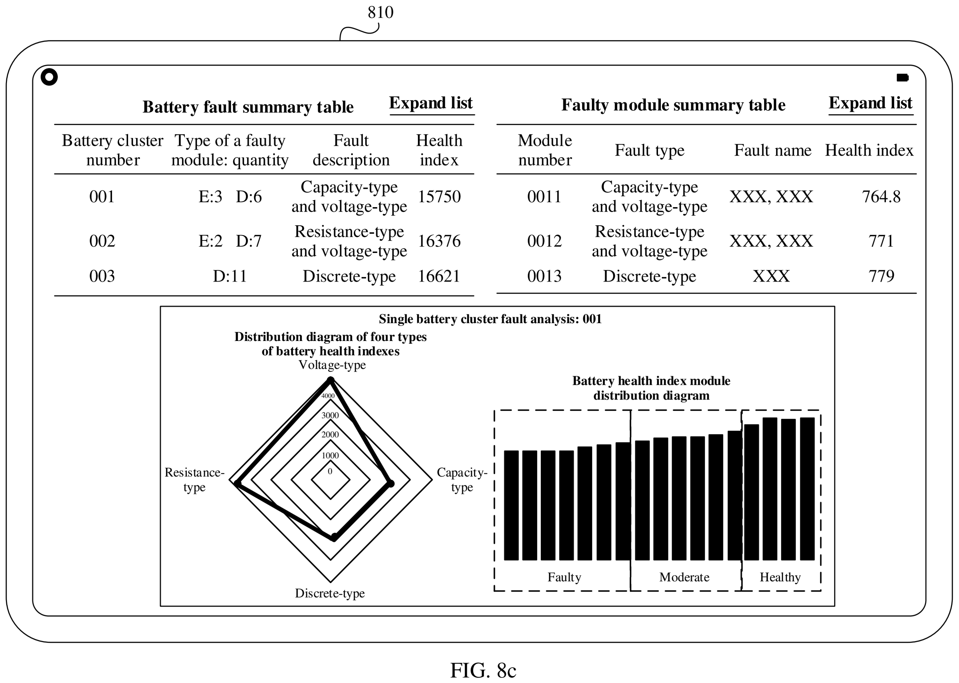

To facilitate understanding of the battery management method provided in this application, with reference to content shown in FIG. 4A to FIG. 4D, FIG. 5a and FIG. 5b, FIG. 6, FIG. 7, FIG. 8a(1) and FIG. 8a(2) to FIG. 8c, FIG. 9, FIG. 10, FIG. 11a to FIG. 11c, FIG. 12a and FIG. 12b, and FIG. 13 to FIG. 15, the following describes an implementation process of the method provided in this application.

First, some profile data that may be used in the following embodiments is described.
(1) a user profile, including but not limited to: a quantity of days of travel on workdays, a quantity of days of travel on holidays, a mileage of travel on a workday, a mileage of travel on a holiday, and a mileage of traveling at a speed higher than 40 kilometers per hour (km/h) per kilometer; a frequency of traveling at a speed higher than 40 km/h per kilometer, a frequency at which an acceleration changes from positive to negative per kilometer, a maximum acceleration value, an average acceleration value, a maximum deceleration value, and an average deceleration value; average charging time at which a battery is not fully charged on a workday, maximum charging time at which a battery is not fully charged on a workday, average charging time at which a battery is fully charged on a holiday, minimum charging time at which a battery is fully charged on a holiday, a standard deviation of charging time at which a battery is not fully charged on a holiday, a quantity of charging times per kilometer, a quantity of full charging times per kilometer, a proportion of a quantity of times that a state of charge is greater than, for example, 70% at the beginning of charging to a total quantity of charging times, a proportion of a quantity of charging times that a state of charge is less than, for example, 10% at the beginning of charging to a total quantity of charging times, a proportion of a quantity of charging times that a temperature is higher than, for example, 30 degrees Celsius (°C) when a battery remains idle to a total quantity of charging times, for example, a proportion of a quantity of charging times at 30°C to a total mileage, a proportion of a quantity of charging times when charging waiting time is less than 5 minutes to a total quantity of charging times, and a proportion of a quantity of charging times when a charging current is 0 ampere (A) at the beginning of charging to a total quantity of charging times; a peak-valley price difference, and a quantity of power blackouts; and a maximum power, a minimum power, a power standard deviation, a maximum current, a minimum current, a current standard deviation, a maximum state of charge, a minimum state of charge, and a state of charge standard deviation.
(2) an environment profile, including but not limited to: an annual average temperature, an annual maximum temperature, an annual minimum temperature, an annual temperature standard deviation, an annual temperature discrete coefficient, an annual average humidity, an annual maximum humidity, an annual minimum humidity, an annual humidity standard deviation, an annual humidity discrete coefficient, and an annual average atmospheric pressure of a vehicle location in which a user is located.
(3) a battery profile, including but not limited to: a state of charge when a current per kilometer is greater than, for example, 50 A, a frequency at which a current per kilometer is greater than, for example, 50 A, a state of charge when a current per kilometer is less than, for example, -10 A, a frequency at which a current per kilometer is less than, for example, -10 A, and a state of charge when a first-order derivative of a current and time per kilometer is negative.
(4) a device profile, including but not limited to: a device equipped with a lithium iron phosphate positive electrode, a device equipped with a single-phase inverter and a three-phase inverter, an average value of a driving distance between a charging pile and a home, a maximum value of a driving distance between a charging pile and a home, a minimum value of a driving distance between a charging pile and a home, a discrete coefficient of a driving distance between a charging pile and a home, a proportion of a quantity of charging times of using a slow charging pile to a total quantity of charging times, a proportion of a quantity of charging times of using a fast charging pile to a total quantity of charging times, an average value of a power standard deviation of each charging, and a capacity of an energy storage device being less than, for example, 10 kilowatt-hours (kWh).
(5) a power generation profile, including but not limited to: a newly-added installed capacity, an energy storage ratio, an energy storage penetration rate, a quantity of operating days, an average current, a maximum current, a current discrete coefficient, an average power, a maximum power, a power discrete coefficient, a start/stop frequency of a state of charge of each charging unit, a start/stop frequency of a state of charge of each discharging unit, and operation and maintenance costs.
(6) a power grid profile, including but not limited to: a backup power capacity, an average voltage, a maximum voltage, a voltage standard deviation, a voltage change frequency, an average current, a maximum current, a current discrete coefficient, an average power, a maximum power, a power discrete coefficient, a start/stop frequency of a state of charge of each charging unit, a start/stop frequency of a state of charge of each discharging unit, and operation and maintenance costs.
(7) a carbon footprint profile, including but not limited to: carbon emissions in a manufacturing process, carbon emissions in a daily use process, carbon emissions consumed by a clean energy device, maximum carbon emissions saved by a clean energy device every day, average carbon emissions caused by power grid electricity consumption every day, maximum carbon emissions caused by power grid electricity consumption every day, a standard deviation of carbon emissions caused by power grid electricity consumption every day, and a change feature curve of carbon emissions in a full life cycle.
(8) a production profile, including but not limited to: a big data analysis system for production, and a big data analysis system for quality inspection, for example, a supplier, a production process, a production batch, a quality inspection item, and a quality inspection threshold.

In addition, features in the foregoing profiles are combined, to obtain a change feature curve of a combined feature parameter in a full life cycle. The profile data includes but is not limited to: a combined profile in which a mileage of travel on a workday is greater than, for example, 120 kilometers and a proportion of a quantity of charging times of using a fast charging pile to a total quantity of charging times is greater than, for example, 90%; a combined profile in which a proportion of a quantity of full charging times is greater than, for example, 85% and a proportion of a quantity of charging times that a temperature is higher than, for example, 40°C when a battery remains idle to a total quantity of charging times is greater than, for example, 75%; and a combined profile in which a capacity of an energy storage device equipped with a lithium iron phosphate positive electrode material is less than, for example, 10 kWh and a maximum used power of the energy storage device is greater than, for example, 3 kW. It should be noted that features included in different profiles may be combined. This is not limited in this application. In addition, an embodiment of this application may further provide a change feature curve of a combined feature parameter in a full life cycle of a battery.

The method provided in embodiments of this application may be applied to a device, and may be specifically applied to optimizing and managing a battery included in the device, or may be specifically applied to optimizing and managing a battery included in another device. In this way, a battery service life can be extended, and a state of health of the battery can be ensured. According to the method, a target battery management strategy may be provided for a user based on feature analysis of battery data such as battery usage data, and battery management may be performed on a battery by using the target battery management strategy. The target battery management strategy may include but is not limited to retaining a healthy usage habit of the user, generating prompt information for a usage habit that can be improved, generating a management strategy for a bad usage habit, and the like. In this way, the battery of the device is intervened as early as possible, so that an attenuation speed of battery health can be slowed down, and a battery service life can be extended.

In a possible embodiment, based on a software as a service (software as a service, SaaS) architecture, a device may interact with a cloud. The device end provides collected data, and the cloud performs data analysis, calculation, and the like, to generate a battery health report, a battery management strategy, and the like. Then, the device end may display the battery health report, the battery management strategy, and the like. For example, the battery health report and the battery management strategy that are generated by the cloud may be provided to a device on a user side, and may be provided to an after-sales end on an enterprise side, or may be provided to a third party, for example, a battery recycling party or an insurance assessment party. It may be understood that, in this embodiment of this application, an application scenario of the battery management method provided in this application is not limited. In addition, in different application scenarios, specific content of the generated battery health report and battery management strategy may be the same or different. For example, a battery health report provided for a user end may be specific for a battery state of health of a device of a user, and a battery health report provided for an after-sales end may be a cluster analysis result, a classification analysis result, or the like of battery states of health of a plurality of devices on an entire network.

For ease of understanding, in the following embodiments, an example in which a device is a mobile phone is used. With reference to the accompanying drawings, a plurality of scenarios that may be involved in the method provided in this application are described. It may be understood that the method provided in embodiments of this application is not limited to being applied to various scenarios described below.

### Application scenario 1

FIG. 4A to FIG. 4D are interface diagrams of a battery management method according to an embodiment of this application. An interface 410 is displayed in FIG. 4A. The interface 410 is a home screen display interface of a mobile phone, and includes icons of various applications (applications, APPs) installed on the mobile phone, for example, may include a "Settings" APP that is focused on in embodiments of this application. The "Settings" APP is used to set and manage some functions related to the mobile phone. The mobile phone may display an interface 420 in response to a user operation on the "Settings" APP. The interface 420 is a home page display interface of the "Settings" APP, and includes setting entries of various mobile phone functions, for example, may include setting entries of functions such as a wireless local area network (wireless local area network, WLAN), Bluetooth, and a mobile network, and may further include a setting entry of a function of a battery 401. Then, the mobile phone may display an interface 430 in response to a user operation on the battery 401. The interface 430 is a battery setting interface, and includes a setting control, a setting entry, or the like for some battery-related functions. For example, the interface 430 may include an "Optimize battery usage" control, a control used to enable or disable a power saving mode, a control used to enable or disable an ultra power saving mode, and the like, and may further include a setting entry of battery management 402 that is focused on in embodiments of this application, or a setting entry of more battery settings 403. Optionally, related functions and content in the battery management method provided in this embodiment of this application may be set in the more battery settings 403. In this case, the interface 430 may not include the independent battery management 402. Optionally, related functions and content in the battery management method provided in this embodiment of this application may be set in the battery management 402. For example, the mobile phone displays an interface 440 in response to a user operation on the more battery settings 403. In addition to a maximum capacity 101 (which may also be understood as a "battery capacity index" in this embodiment of this application) and a smart charging mode control 102 described in FIG. 1, the interface 440 may further include a battery health index 404 in this embodiment of this application. It can be learned from the interface 440 that an index representation form of the battery health index 404 is different from that of a maximum capacity. For example, an index range of the battery health index 404 may be set to but is not limited to the following index ranges: [0, 10], [0, 1000], [300, 800], [450, 1200], and the like.

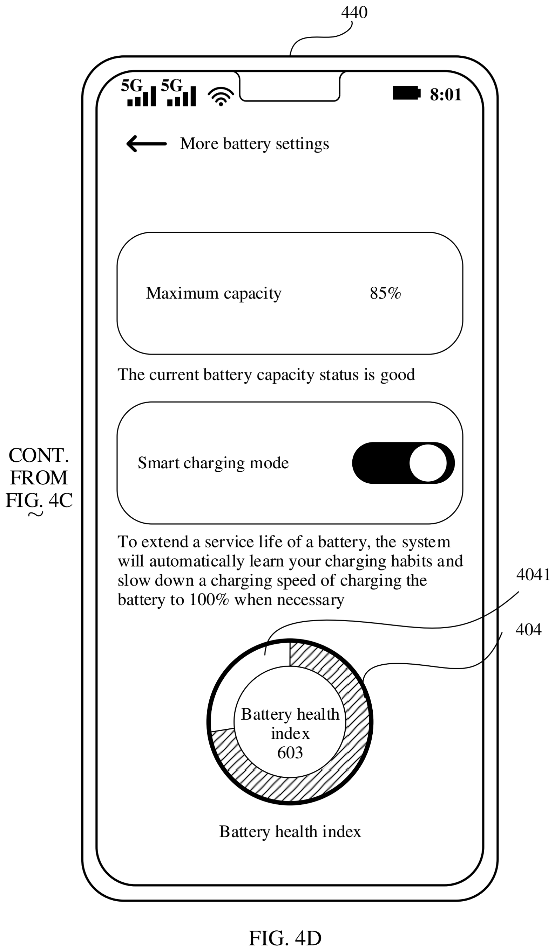

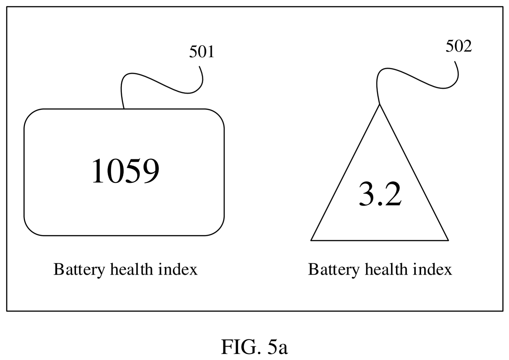

It should be noted that, in some other possible embodiments, a representation form of the battery health index is not limited to the representation form of the battery health index 404 shown on the interface 440 in FIG. 4D. For example, FIG. 5a shows several other possible representation forms of a battery health index in the battery management method according to an embodiment of this application. For example, as shown in FIG. 5a, a battery health index 501 is represented by using a rectangle, or a battery health index 502 is represented by using a triangle. It may be understood that battery health indexes in different representation forms may correspond to different index ranges. Therefore, index values of battery health indexes indicated by the mobile phone in different representation forms may be different. For example, an index value corresponding to the battery health index 501 is 1059, and an index value corresponding to the battery health index 502 is 3.2.

In addition, it should be further noted that the battery health index is a new index that can reflect a battery state of health, and may be determined by using, but not limited to, one or a combination of the following indexes: a capacity-type battery health index, a voltage-type battery health index, a resistance-type battery health index, and a discrete-type battery health index.

The capacity-type battery health index may be used to reflect a feature of a specific capacity in a battery charging process and/or a battery discharging process.

The voltage-type battery health index may be used to reflect features of one or more of battery voltage parameters, such as an equilibrium electric potential, an average voltage, a platform voltage, a median voltage, a peak height in an incremental voltage curve, an integral area, and a voltage value corresponding to a peak position.

The resistance-type battery health index may be used to reflect features of one or more of resistance parameters such as a direct current resistance and a polarization resistance of a battery.

The discrete-type battery health index is used to reflect features of one or more of parameters such as consistency of a voltage-type battery health index and a sub-index of the voltage-type battery health index, consistency of a capacity-type battery health index and a sub-index of the capacity-type battery health index, consistency of a resistance-type battery health index and a sub-index of the resistance-type battery health index, voltage consistency, current consistency, temperature consistency, and force consistency.

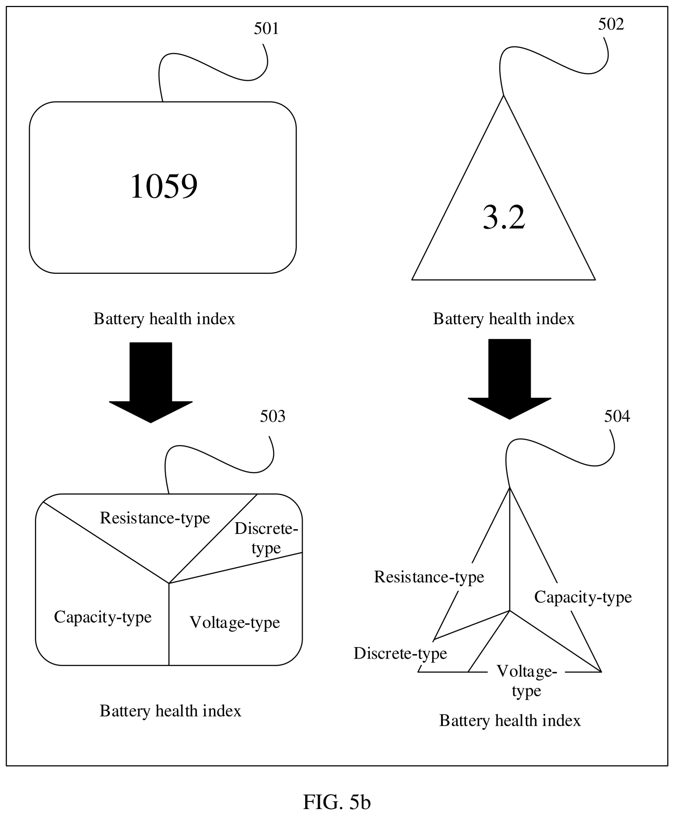

In comparison with that shown in FIG. 1 in which the battery state of health is reflected only by using the maximum capacity of the battery, the battery state of health can be more comprehensively reflected by using the battery health index. In some embodiments, the battery health index may be obtained by a server by performing statistical analysis based on battery data. For example, the capacity-type battery health index, the voltage-type battery health index, the resistance-type battery health index, and the discrete-type battery health index may be obtained by performing statistical analysis based on some physical data of a battery. It may be understood that, in this embodiment of this application, on the interface 440, the battery health index 404 may be provided, and one or more of a capacity-type battery health index, a voltage-type battery health index, a resistance-type battery health index, and a discrete-type battery health index may be provided for the user. For example, FIG. 5b is a diagram of proportional relationships between various types of battery health indexes according to an embodiment of this application. As shown in FIG. 5b, in addition to the battery health index 501 or the battery health index 502, a battery health index 503 or a battery health index 504 may be represented. Optionally, the battery health index 503 may be, for example, obtained through switching after a touch operation is performed on the battery health index 501, and the battery health index 504 may be, for example, obtained through switching after a touch operation is performed on the battery health index 502. The battery health index 503 or the battery health index 504 may indicate a level of impact of various types of battery health indexes on the battery health index. Optionally, the battery health index 503 or the battery health index 504 may alternatively be directly displayed on an interface, a jump interface, or the like. In addition, a representation form of degrees of impact of various types of battery health indexes on the battery health index is not limited in this embodiment of this application, for example, may be shown by the battery health index 503 or the battery health index 504 in FIG. 5b, or may be displayed in a chart, a sector chart, a circle, a text, a table, and a percentage. In this way, the user can also learn of the battery state of health from different perspectives.

It may be understood that, in the embodiment described in FIG. 4A to FIG. 4D, the battery management function is provided in the "Settings" APP. During specific implementation, the battery management function may be further provided in an entry such as another APP or another interface. For example, the battery management function may be provided in the "Battery safety guardian" APP, or the battery management function may be woken up by using a voice instruction, or the battery management function may be provided in a manner like an applet, to trigger battery management.

In some other embodiments, after detecting a preset condition, the mobile phone may alternatively display, to the user in one or a combination of forms such as a pop-up window, a voice reminder, and automatic interface jumping, an interface or an interface entry including a battery health report. For example, the preset condition may include but is not limited to one or more of the following conditions: a preset temperature state, preset time, a preset use state, and a preset state of health. In this way, in this implementation, the user can perceive the battery state of health timely, so that battery management can be performed in a timely and accurate manner, and a battery service life can be extended.

Further, in some embodiments, the mobile phone may further display aging rate information for the battery health index to the user. The aging rate information may reflect an attenuation speed of the battery health index. It may be understood that a larger value of an aging rate indicates a faster attenuation speed of the battery health index. The aging rate may be reduced by changing the battery management strategy. It may be understood that the mobile phone may obtain a current aging rate based on a current battery management strategy, and the mobile phone may obtain a target aging rate based on a changed target battery management strategy. For example, in a representation form of the battery health index shown in FIG. 4A to FIG. 4D, the battery health index 404 may further include a display region 4041 that indicates a decreaseable amplitude of an aging rate. The decreaseable amplitude of the aging rate indicates a proportion of a difference between the current aging rate and the target aging rate to the target aging rate. The display region 4041 may indicate the user to change the current battery management strategy for the battery. By changing the battery management strategy, the current aging rate of the battery health index can be reduced, an attenuation speed of battery health can be slowed down, and a battery service life can be extended.

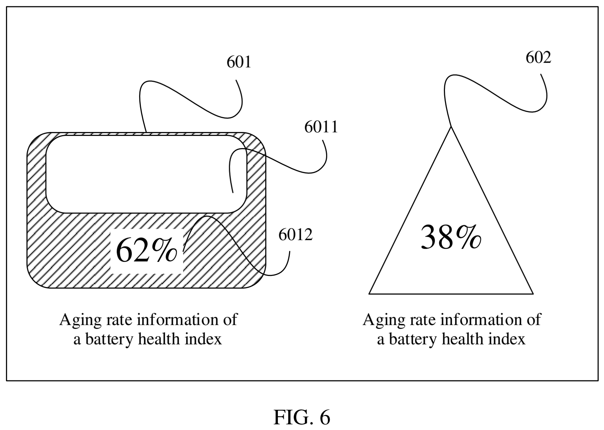

It should be noted that, in some other possible embodiments, a representation form of the aging rate of the battery health index is not limited to the display region 4041 shown on the interface 440 in FIG. 4D. For example, FIG. 6 shows several other possible representation forms of the aging rate information of the battery health index in the battery management method according to an embodiment of this application. For example, aging rate information 601 of a battery health index shown in FIG. 6 may include a graphic display region 6011 and a prompt text 6012. The graphic display region 6011 may indicate a battery health management degree of a management strategy at a current aging rate compared with a management strategy at a target aging rate. The prompt text 6012 may indicate a decreaseable amplitude of the current aging rate of a battery. For another example, FIG. 6 further shows aging rate information 602 of the battery health index. In 602, a percentage may further indicate that the current aging rate of the battery health index of the user can be further reduced and may indicate a decreaseable amplitude proportion, for example, may indicate that the current aging rate can be further reduced by 38%. In this way, in response to a user operation used of the user to reduce the aging rate, the mobile phone can switch from the current battery management strategy to the target battery management strategy, so that a battery health management degree can be improved, an attenuation speed of battery health can be slowed down, and a battery service life can be extended.

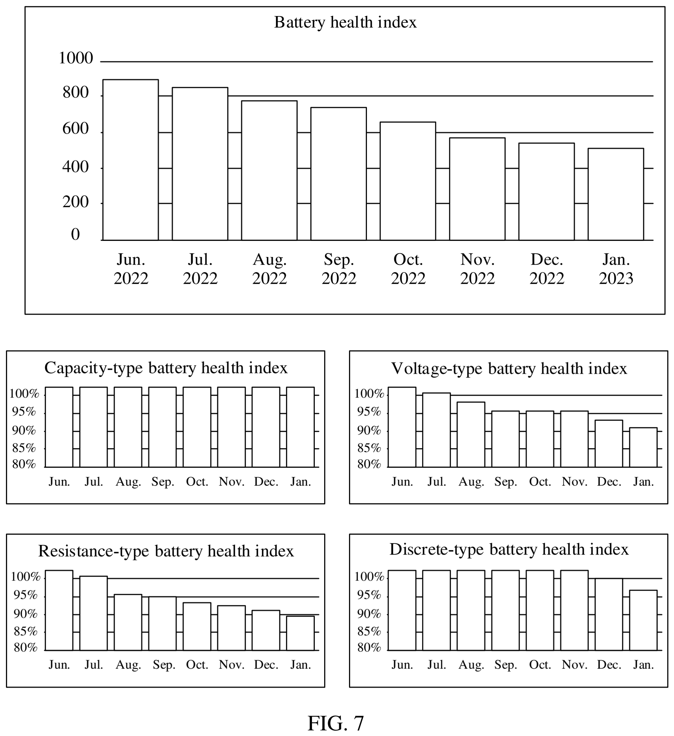

The mobile phone may further display one or a combination of all historical trends, some historical trends, a historical trend in a specified period, and a future predicted trend of the battery health index to the user. A time span used to display the trend of the battery health index is not limited in this embodiment of this application, for example, the time span may be a preconfigured time span, a time span starting from use of the battery of the mobile phone, or the like. In this way, the user may also learn of aging rate information of the battery health index from a historical trend, and learn of an attenuation status of battery health. For example, FIG. 7 is a time trend diagram of a battery health index in a battery management method according to an embodiment of this application. For example, the battery health index displayed in the time trend diagram shown in FIG. 7 includes but is not limited to one or more of the following trends: a battery health index, a capacity-type battery health index, a voltage-type battery health index, a resistance-type battery health index, a discrete-type battery health index, and the like. It can be seen from FIG. 7 that, as a battery of a mobile phone is used, the battery health index gradually attenuates. It can be understood that a time trend of the battery health index may be affected by one or more of the capacity-type battery health index, the voltage-type battery health index, the resistance-type battery health index, and the discrete-type battery health index. In addition, it may be further understood that, with reference to the description of the aging rate information of the battery health index described in the foregoing embodiment, battery health is managed, so that attenuation speeds of various battery health indexes can be reduced, and a battery service life can be extended. It may be understood that, as the battery is used, a resistance of the battery gradually increases. Therefore, the resistance-type battery health index and the battery health index may gradually attenuate as the resistance of the battery increases. Therefore, during implementation of this application, a negation operation, a reciprocal operation, or the like may be performed on the resistance of the battery. In addition, for other data similar to a change rule of the resistance of the battery, refer to negation operation or reciprocal operation processing on the resistance of the battery. Details are not described herein again.

In some embodiments, the aging rate information may be further analyzed as a determining basis for detecting a battery fault. For example, when an attenuation speed of a battery health index relative to a previous battery health index exceeds a specific attenuation speed threshold, an alarm, prompt information, a pop-up window, or the like may be sent, so that a battery fault can be checked in time, and/or automatic overhaul processing can be triggered.

In an optional example, the time trend diagram of the battery health index shown in FIG. 7 may be displayed on the interface 440 in FIG. 4D, and the user may slide the interface 440 upward to display more information. For another example, the time trend diagram of the battery health index shown in FIG. 7 may alternatively be stored in a cloud, and a back-end technician may display the time trend diagram after invoking the time trend diagram by using any device.

By using time trends of various battery health indexes, statistics collection and analysis can be performed on an attenuation status of the battery health index, so that a battery management strategy can be determined. A specific determining manner is described in detail in a subsequent embodiment, and details are not described herein. In addition, it may be further convenient for the user to view and learn of the battery state of health, so that battery management, strategy optimization, and the like can be performed timely.

In some embodiments, FIG. 8a(1) and FIG. 8a(2) are other interface diagrams of a battery management method according to an embodiment of this application. An interface 450 in FIG. 8a(1) may include a "Learn more" control 801. The interface 450 may be obtained by the mobile phone in response to a slide upward operation performed by the user on the interface 440 shown in FIG. 4D. The mobile phone may display an interface 460 in response to a user operation on the "Learn more" control 801. The interface 460 may be used to describe content such as data related to battery management. For example, the content may include but is not limited to the following content shown on the interface 460: significance of the battery health report, composition of the battery health index, the aging rate of the battery health index, a difference between the battery health index and the aging rate of the health index, and a battery usage encyclopedia, to help the user better manage the battery.

The battery health report may include but is not limited to information such as the battery health index, the aging rate of the battery health index, and the time trend of the battery health index that are described in the foregoing embodiments. For example, for ease of classification, the interface 440 or the interface 450 may include a "Battery health report" control. Information such as but not limited to the battery health index, the aging rate of the battery health index, and the time trend of the battery health index may be displayed a corresponding page of the "Battery health report".

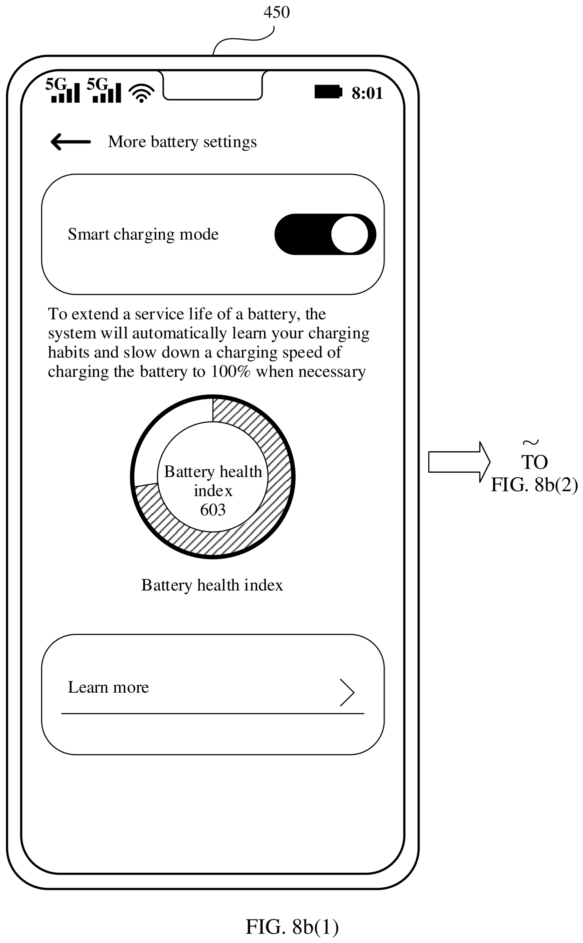

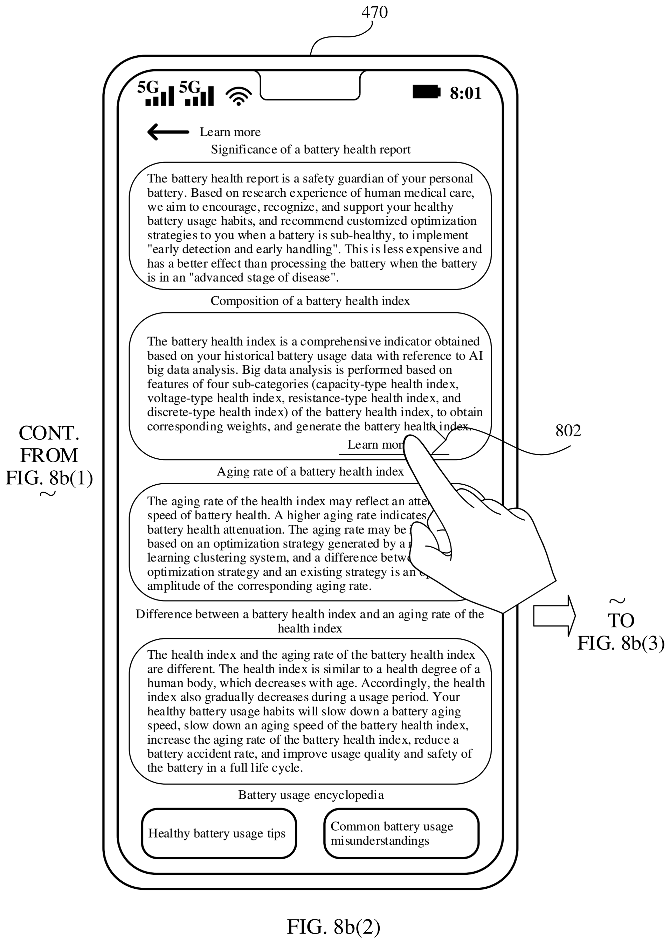

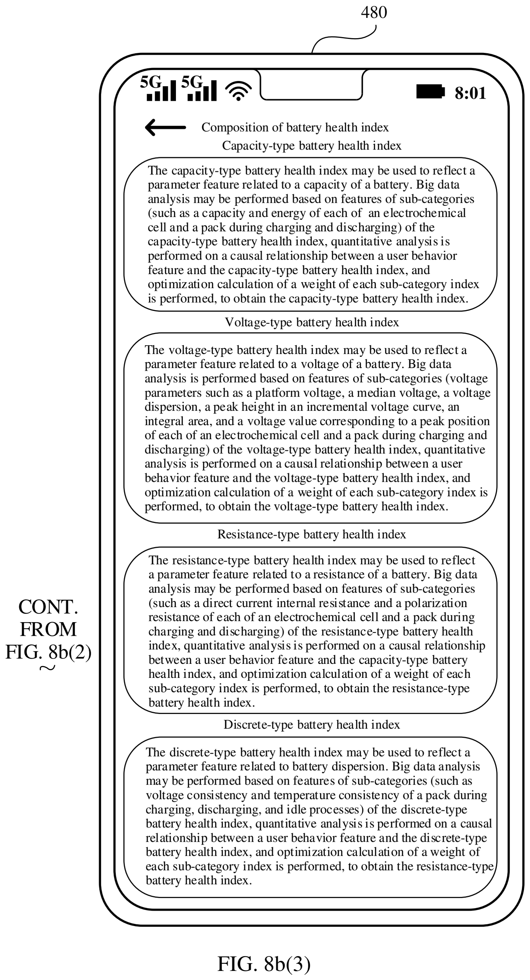

For another example, the battery health report may further include various types of battery health indexes described in the foregoing embodiments. For example, FIG. 8b(1) to FIG. 8b(3) are still other interface diagrams of a battery management method according to an embodiment of this application. Compared with the interface 460 in FIG. 8a(2), an interface 470 may be displayed in FIG. 8b(2). The composition of the battery health index included in the interface 470 may further include a "Learn more" control 802. The mobile phone may display an interface 480 in response to a user operation on the control 802 on the interface 470. The interface 480 may include descriptions of the capacity-type battery health index, the voltage-type battery health index, the resistance-type battery health index, and the discrete-type battery health index that make up the battery health index.

For example, a description of the capacity-type battery health index is, for example, "The capacity-type battery health index may be used to reflect a parameter feature related to a capacity of a battery. Big data analysis may be performed based on features of sub-categories (such as a capacity and energy of each of an electrochemical cell and a pack during charging and discharging) of the capacity-type battery health index, quantitative analysis is performed on a causal relationship between a user behavior feature and the capacity-type battery health index, and optimization calculation of a weight of each sub-category index is performed, to obtain the capacity-type battery health index". The pack refers to a battery pack.

For another example, a description of the voltage-type battery health index is, for example, "The voltage-type battery health index may be used to reflect a parameter feature related to a battery voltage. Big data analysis is performed based on features of sub-categories (voltage parameters such as a platform voltage, a median voltage, a voltage dispersion, a peak height in an incremental voltage curve, an integral area, and a voltage value corresponding to a peak position of each of an electrochemical cell and a pack during charging and discharging) of the voltage-type battery health index, quantitative analysis is performed on a causal relationship between a user behavior feature and the voltage-type battery health index, and optimization calculation of a weight of each sub-category index is performed, to obtain the voltage-type battery health index".

For another example, a description of the resistance-type battery health index is, for example, "The resistance-type battery health index may be used to reflect a parameter feature related to a resistance of a battery. Big data analysis may be performed based on features of sub-categories (such as a direct current internal resistance and a polarization resistance of each of an electrochemical cell and a pack during charging and discharging) of the resistance-type battery health index, quantitative analysis is performed on a causal relationship between a user behavior feature and the capacity-type battery health index, and optimization calculation of a weight of each sub-category index is performed, to obtain the resistance-type battery health index".

For another example, a description of the discrete-type battery health index is, for example, "The discrete-type battery health index may be used to reflect a parameter feature related to a battery dispersion. Big data analysis may be performed based on features of sub-categories (such as voltage consistency, current consistency, and temperature consistency of a pack during charging, discharging, and idle processes) of the discrete-type battery health index, quantitative analysis is performed on a causal relationship between a user behavior feature and the discrete-type battery health index, and optimization calculation of a weight of each sub-category index is performed, to obtain the resistance-type battery health index". A dispersion degree of the pack may be obtained through aggregation based on a feature of an electrochemical cell.

It should be noted that an implementation of the display interface 480 is not limited in this embodiment of this application. For example, in addition to the control 802 that is used as a trigger entry, a display card corresponding to "composition of the battery health index" may be used as a trigger entry, a trigger entry may be set at a bottom position of the interface 470, or a floating control is used. In addition, description content and display forms of various types of battery health indexes on the interface 480 are not limited in this embodiment of this application. The interface 480 is merely a possible example. For example, the interface 480 may be in a tile form, or may be in a card stacking form, a chart form, or the like. In addition, sub-categories reflected by various types of battery health indexes may be obtained with reference to profile data, and the sub-categories may also be understood as features. For example, the features may be obtained based on information such as a user profile, an environment profile, a battery profile, a device profile, a power generation profile, a power grid profile, a carbon footprint profile, and a production profile.

For another example, there are different compositions of a battery in different scenarios or devices, for example, a mobile phone may usually include an electrochemical cell. Composition of a battery may include but is not limited to a form such as an electrochemical cell, a battery module, a battery pack (pack), or a battery cluster. An electrochemical cell is a most basic component of a battery. A plurality of electrochemical cells may form one battery module, and a plurality of battery modules may form one battery pack or battery cluster. For example, a 3C electronic product may include an electrochemical cell; a new energy vehicle may include an electrochemical cell, a battery module, and a pack; a residential energy storage device may include an electrochemical cell, a battery module, a battery cluster; and a commercial energy storage plant may include an electrochemical cell, a battery module, a battery cluster, a battery subsystem, a battery subarray, and the like.

Therefore, in this embodiment of this application, in different scenarios, the battery state of health may be reflected from a plurality of battery composition forms at different levels, and the battery state of health may be reflected by combining battery composition forms at different levels. For example, the battery health report may include a battery state of health analyzed at each level, and an impact relationship between battery states of health at different levels. For example, a battery state of health of the battery cluster may be obtained through analysis in a manner such as addition and/or weighted summation by using a battery state of health of each constituent battery module as a feature factor. For another example, a battery state of health of the battery module may also be obtained through analysis in a manner such as addition and/or weighted summation by using a battery state of health of each constituent electrochemical cell as a feature factor.

FIG. 8b(1) to FIG. 8b(3) describe a scenario in which a device is a mobile phone. Composition of a battery may be, for example, an electrochemical cell and a battery pack. It should be noted that the mobile phone may alternatively include only an electrochemical cell. For example, FIG. 8c is still another interface diagram of a battery management method according to an embodiment of this application. An interface 810 shown in FIG. 8c may include a battery fault summary table, a faulty module summary table, and single battery cluster fault analysis.
(1) The battery fault summary table may be used to obtain a battery state of health of each battery cluster from a battery cluster level. For example, the battery fault summary table may include but is not limited to: a battery cluster number, a type of a faulty module: quantity, a fault description, a health index, and the like. The health index in the table may be obtained by performing addition and/or weighted summation based on a health index of each constituent battery module. For example, it can be learned from FIG. 8c that a range of the health index of the battery cluster included in the battery fault summary table is greater than a range of a health index of the battery module included in the faulty module summary table.

In addition, it may be further learned from the battery fault summary table that multilevel aggregation analysis may be further performed on the battery state of health of the battery cluster. For example, battery state of health analysis may be performed with reference to a sub-category (for example, a capacity-type fault or a voltage-type fault). For another example, the battery state of health may be analyzed with reference to a fault type of the battery module and a quantity corresponding to a fault type.

In addition, the battery fault summary table shown on the interface 810 may be partial, and more content or all content of the battery fault summary table may be displayed by using an "Expand list" control.

(2) The faulty module summary table may be used to obtain a battery state of health of each battery module from a battery module level. For example, the faulty module summary table may include but is not limited to: a module number, a fault type, a fault name, a health index, and the like. The health index in the table may be obtained by performing addition and/or weighted summation based on a health index of each constituent electrochemical cell.

In addition, it may also be learned from the faulty module summary table that multilevel aggregation analysis may also be performed on the battery state of health of the battery module. For example, the battery state of health may be analyzed with reference to a sub-category (for example, a capacity-type fault or a voltage-type fault). For another example, the battery state of health may be analyzed with reference to a fault name of the battery module, and the fault name may be, for example, an electrochemical cell-level feature.

For example, the fault module summary table may be obtained in response to triggering a battery cluster 001 in the battery fault summary table. For example, when it is detected that a touch operation is performed on a region corresponding to the battery cluster 001, the faulty module summary table shown on the interface 810 may be displayed in response to the touch operation. A battery module 0011, a battery module 0012, and a battery module 0013 included in the faulty module summary table may be three battery modules that form the battery cluster 001.

In addition, the faulty module summary table shown on the interface 810 may be partial, and more content or all content of the faulty module summary table may be displayed by using an "Expand list" control.

(3) The single battery cluster fault analysis may be used to analyze a battery state of health of a battery cluster from different levels. A distribution diagram of four types of battery health indexes and a battery health index module distribution diagram are shown on the interface 810. Based on the distribution diagram of the four types of battery health indexes, it can be learned that distribution proportions of the voltage-type health index and the resistance-type health index of the battery cluster are large, and distribution proportions of the capacity-type health index and the discrete-type health index of the battery cluster are small. Distributions of a faulty battery module, a moderate battery module, and a healthy battery module may be obtained based on the battery health index module distribution diagram.

It should be noted that FIG. 8c is merely a possible example. A presentation form and specific presentation content of the battery state of health are not limited in this embodiment of this application.

Battery state of health analysis is performed across a plurality of levels and a set of the levels, so that more fine-grained and more accurate battery health management can be implemented.

It may be understood that a manner of displaying the data related to battery management is not limited in this embodiment of this application. FIG. 4A to FIG. 4D to FIG. 8c are merely possible examples.

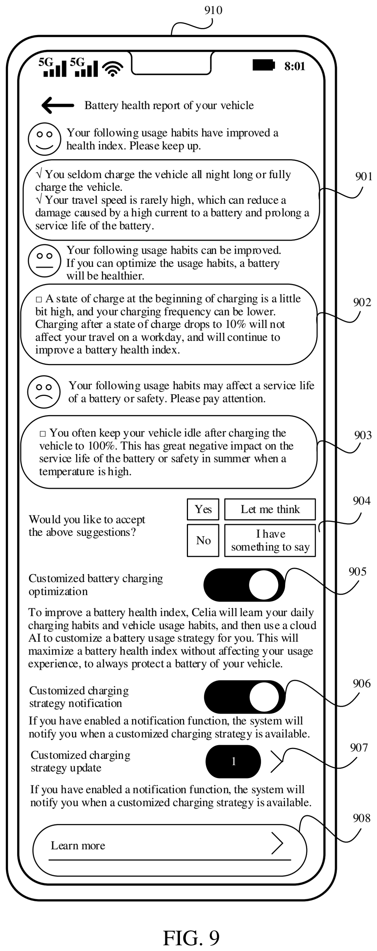

In some other embodiments, FIG. 9 is still another interface diagram of a battery management method according to an embodiment of this application. For example, the device is a new energy vehicle, but battery management is performed with assistance of a mobile phone. An APP used to manage the new energy vehicle may be installed in the mobile phone. In this embodiment of this application, a battery management function may be provided in the APP, so that a user may perform battery management on a battery of the new energy vehicle by using the battery management function included in the APP. For an implementation of battery management, refer to the content described in FIG. 4A to FIG. 4D to FIG. 8c. An interface 910 in FIG. 9 shows a battery health report of a vehicle that is obtained by the mobile phone or a cloud based on information such as a battery health index. For example, the battery health report may include but is not limited to one or more of the following content:
(1) Healthy habit. Display content 901 shown on the interface 910 may present, to the user, a usage habit that does not have great impact on the battery health index and that is healthy.
(2) Optimizable habit. Display content 902 shown on the interface 910 may display, to the user, a usage habit that has small impact on the battery health index and that can be further improved, to match a corresponding optimization suggestion for display.
(3) Habit that needs to be optimized urgently. Display content 903 shown on the interface 910 may present, to the user, a usage habit that has great impact on the battery health index and that is very unhealthy. Optionally, to remind the user timely, one or a combination of manners such as a text message, a call, a prompt pop-up window, and a prompt text may be further configured, to be presented to the user.

It should be noted that various habits in the battery health report may be obtained through analysis based on data that includes but is not limited to battery usage data based on various real working conditions (including but not limited to processes such as device charging, device discharging, and device remaining idle), and environment data (including but not limited to a temperature, a pressure, and humidity).

(4) Strategy interaction feedback. Display content 904 shown on the interface 910 may provide a plurality of controls that can be used by the user to provide feedback on a battery management strategy. For example, the plurality of controls may be "Yes", "No", "Let me think", and "I have something to say" shown in the display content 904.

In some possible embodiments, for an "I have something to say" control included in the display content 904, the user may enter a related idea, including but not limited to: questions or ideas about battery usage, questions or ideas about a customized battery strategy, questions or ideas about device usage, questions or ideas about opinions and emotions, and the like. In some embodiments, processing may be performed by using a natural language processing (natural language processing, NLP) method like a large language model (large language model, LLM). Based on related user profile data, related environment profile data, related battery profile data, related device profile data, related power generation profile data, related power grid profile data, related carbon footprint profile data, related production profile data, a related customized optimization strategy, a related target device usage strategy, a related group device usage strategy and rule, a related battery usage encyclopedia, and the like, question and answer or interaction may be performed with the user. In addition, the foregoing information may be used to analyze a user personality profile, and then a knowledge graph for a user profile and strategy optimization is constructed by analyzing a correlation between the user personality profile and battery usage and an optimization strategy acceptance degree, to improve generation efficiency and quality of a customized strategy. In addition, the LLM may further generate customized and humanized interaction information. Content of the interaction information may include but is not limited to a human-pet relationship, a parent-child relationship, a partner relationship, a relationship between a person and a toy, a relationship between a person and a game character, and a relationship between a person and a historical character, and a form of the interaction information may include but is not limited to a text, a voice, a picture, and a video, so that an emotional relationship and an emotional value between the user and the device can be constructed, to enhance use stickiness of the user.

In addition, it should be noted that the entry in the foregoing implementation is not limited to using the "I have something to say" control included in the display content 904, and the entry may alternatively be provided at any position (for example, a bottom region or a side region) on the interface, for example, the entry may be provided in a form of a text input box, and/or the entry may be provided in a form of a floating control, and/or the entry may be provided in a form of a language.

(5) Battery charging optimization, charging strategy notification, and charging strategy update. A control 905, a control 906, and a control 907 shown on the interface 910 may provide the user with optionality of battery charging optimization and optionality of charging strategy notification and update.

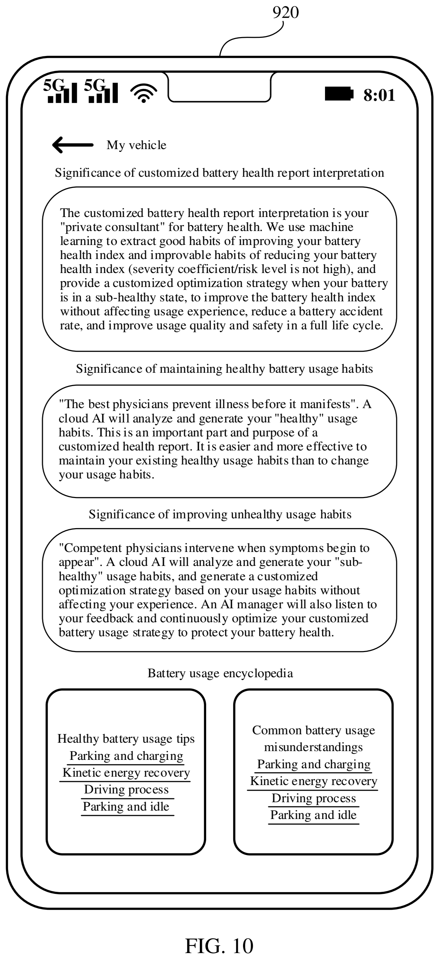

(6) Learn more. A "Learn more" control 908 is shown on the interface 910. For example, the mobile phone displays an interface 920 shown in FIG. 10 in response to a user operation on the "Learn more" control 908. The interface 920 may be used to describe related content and the like of the battery health report. For example, the interface 920 may include but is not limited to: significance of the customized battery health report, significance of maintaining healthy battery usage habits, significance of improving unhealthy usage habits, and a battery usage encyclopedia. It may be understood that, in an actual scenario, content displayed on the interface 920 may be configured based on a service requirement, so that the user can better use the device and learn of the battery health report, to better manage the battery.

Optionally, similar to the battery health report shown in FIG. 9, in this embodiment of this application, the battery health report may alternatively be a battery health report that is of a cluster or category and that is obtained by the cloud by performing feature analysis on devices belonging to the same cluster or category. For example, for devices of the same cluster or category, a healthy habit of the cluster or category, an optimizable habit of the cluster or category, a habit that needs to be optimized urgently of the cluster or category, and the like may be obtained. In this way, any device belonging to the cluster or category can generate a battery health report of the device based on the battery health report of the cluster or category. Devices belonging to a same cluster or category may be devices of a same or similar device type, and/or devices belonging to a same cluster or category may be devices whose profile features are the same or similar based on battery-related data analysis. The profile feature may include but is not limited to a user profile, an environment profile, a battery profile, a device profile, power generation profile data, power grid profile data, carbon footprint profile data, production profile data, and the like. The user profile data, the environment profile data, the battery profile data, and the device profile data are concerned features in the field of vehicle-mounted and 3C electronic products (such as a mobile phone, a tablet, and a notebook computer). The user profile data, the environment profile data, the battery profile data, the device profile data, the power generation profile data, the power grid profile data, the carbon footprint profile data, and the production profile are concerned features in the energy storage field (such as a user scenario, a commercial and industrial industry scenario, a utility-scale scenario, a data center scenario, and a site energy scenario).

(7) Battery health index, aging rate of battery health index, and composition of battery health index. Although not shown in FIG. 9, with reference to FIG. 8a(1) and FIG. 8a(2) to FIG. 8c, the mobile phone or the cloud may also be used to assist in viewing various battery health-related information of the vehicle. A specific implementation is not limited in embodiments of this application.

It should be noted that a form of interpretation of the battery health report and the battery health report shown in FIG. 9 is not limited in embodiments of this application. For example, presentation may be performed in a form of a text, a voice, an animation, a video, a pop-up window, or the like.

### Application scenario 2

In some embodiments, based on interaction between a device and a cloud, the cloud may collect statistics on and analyze data related to battery health from a plurality of devices, so that a back-end technician can manage battery health of one or more devices. For example, battery health reports of devices on an entire network may be generated, and a corresponding battery management strategy may be generated for a device.

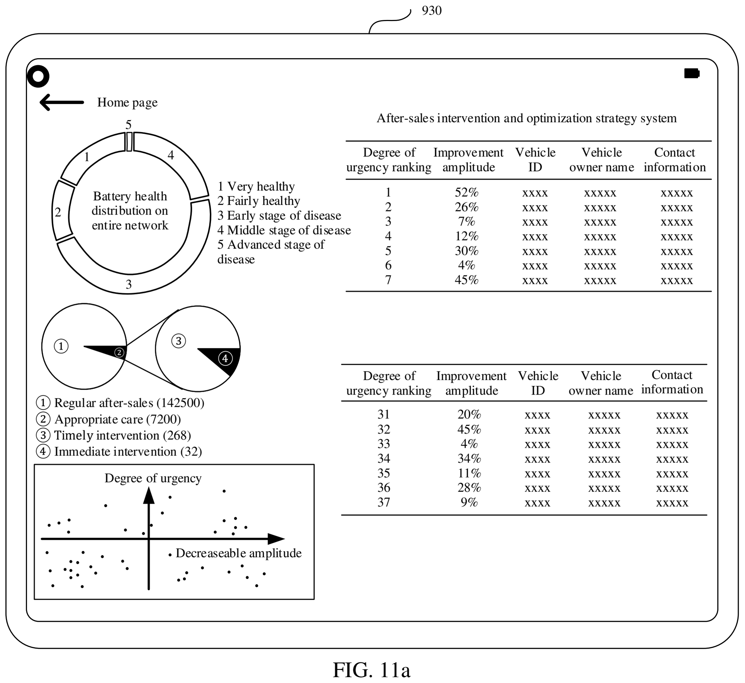

For example, FIG. 11a is an interface diagram of a battery management method according to an embodiment of this application. FIG. 11a may be displayed by using any device connected to the cloud. It can be learned from an interface 930 shown in FIG. 11a that the cloud may collect statistics on battery health distribution information, battery health-based ranking information, a battery after-sales requirement status, a battery after-sales requirement four-quadrant diagram, information included in an after-sales intervention and optimization strategy system, and the like of the devices on the entire network. In this way, it can be convenient for a back-end technician to monitor and manage a state of health of a device. For example, based on the battery after-sales requirement four-quadrant diagram shown on an interface 930, a horizontal coordinate of the four-quadrant diagram may be a decreaseable amplitude of an aging rate of a battery health index of a device, and a vertical coordinate of the four-quadrant diagram may be a degree of urgency of after-sales intervention. It may be understood that a device with a lower battery health index has a higher degree of urgency, indicating a higher need for after-sales intervention, and a larger decreaseable amplitude of an aging rate of a device indicates higher after-sales intervention efficiency. In this way, different battery management strategies may be generated for devices belonging to different quadrants. In addition, an information interface shown on the interface 930 may be displayed based on the battery after-sales requirement four-quadrant diagram and the information included in the after-sales intervention and optimization strategy system, so that a back-end technician can perform after-sales management.

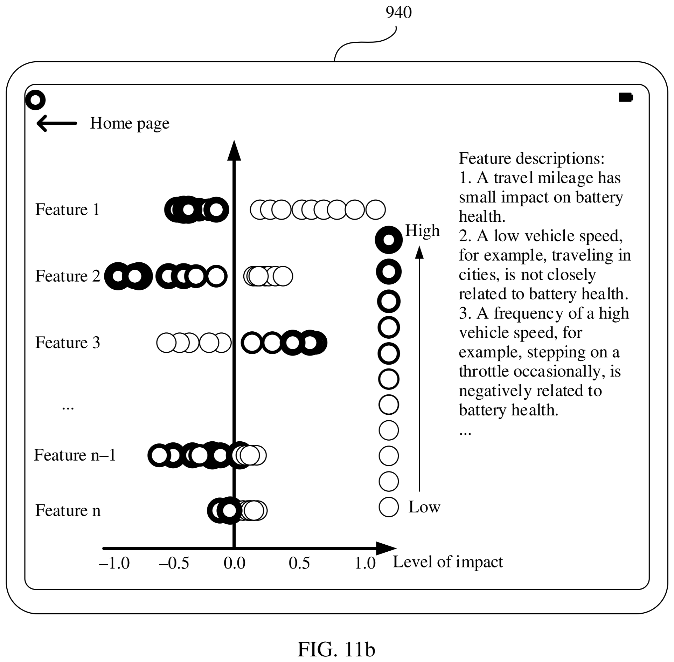

It should be noted that, in this embodiment of this application, specific content and a display form of the battery health reports that are of the devices on the entire network and that are generated by the cloud are not limited. The interface 930 in FIG. 11a is merely a possible example. For example, the battery health reports of the devices on the entire network may further include information about battery health indexes of battery devices on the entire network. For another example, FIG. 11b is another interface diagram of a battery management method according to an embodiment of this application. FIG. 11b shows an interface 940. Display content included on the interface 940 may reflect distribution information and ranking information of various features. The feature may be obtained based on information such as a user profile, an environment profile, a battery profile, a device profile, a power generation profile, a power grid profile, a carbon footprint profile, and a production profile. It may be understood that different device batteries may correspond to different feature values. In FIG. 11b, circles with different thicknesses are used to represent different feature values. A thinner circle may indicate a smaller feature value corresponding to a device battery, and a thicker circle may indicate a larger feature value corresponding to a device battery. In addition, a horizontal axis may represent a level of impact on battery health, where a horizontal coordinate greater than 0.0 may represent positive impact on battery health, and a horizontal coordinate less than 0.0 may represent negative impact on battery health. For example, it can be learned from FIG. 11b that degrees of impact on battery health are ranked in a descending order as follows: a feature 1, a feature 2, a feature 3, ..., and a feature n, where n is a positive integer. For example, the feature 1 in FIG. 11b may be a daily travel mileage. It can be learned from FIG. 11b that when the travel mileage is large, battery health may be negatively affected, and when the travel mileage is small, battery health is generally positively affected. For another example, the feature 3 in FIG. 11b may be charging duration (in a non-full-charged state). It can be learned from FIG. 11b that when the charging duration (in a non-full-charged state) is short, battery health may be negatively affected, and when the charging duration (in a non-full-charged state) is long, battery health is generally positively affected.

In addition, an implementation of after-sales management is not limited in this embodiment of this application. For example, the information interface shown on the interface 930 may be generated, or a user reminder message may be automatically triggered. For example, the reminder message may be sent to contact information associated with the user by using a text message, a phone call, or the like.

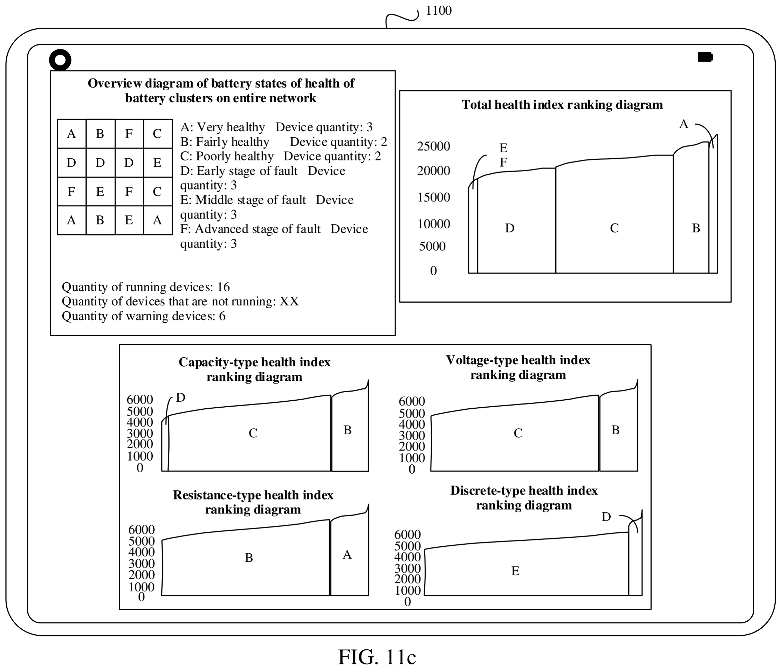

For another example, FIG. 11c is an interface diagram of a battery management method according to an embodiment of this application. FIG. 11c may be displayed by using any device connected to the cloud. It can be learned from an interface 1100 shown in FIG. 11c that the cloud may collect statistics on battery health distribution information of battery clusters on an entire network, ranking information based on battery health indexes, ranking information based on various types of battery health indexes, and the like. In this way, it can be convenient for a back-end technician to monitor and manage a state of health of a battery cluster. For example, based on an overview diagram of battery states of health of the battery clusters on the entire network shown on the interface 1100, battery health distribution statuses of the battery clusters on the entire network may be viewed from the overview diagram, for example, quantities of devices in different states of health may be viewed, so that global battery management of the battery clusters on the entire network can be implemented. For another example, based on a total health index ranking diagram shown on the interface 1100, the battery clusters on the entire network may be ranked based on the battery health indexes. In addition, devices in different states of health are represented in different forms. Although not shown in FIG. 11c, devices in different states of health may be represented by different colors. For example, devices in states of health at levels E and F may be represented by red, a device in a state of health at a level D may be represented by yellow, a device in a state of health at a level C may be represented by light green, a device in a state of health at a level B may be represented by medium green, and a device in a state of health at a level A may be represented by dark green. For another example, based on various types of battery health index ranking diagrams shown on the interface 1100, the battery clusters on the entire network may be ranked based on various types of battery health indexes, to obtain distribution of the battery clusters on the entire network on different types of battery health indexes. For example, it can be learned from the interface 1100 that a discrete-type battery health index of the battery clusters on the entire network is low, and a resistance-type battery health index is good. Therefore, it indicates that consistency of the battery clusters on the entire network is poor, and consistency of the battery clusters needs to be paid attention to.

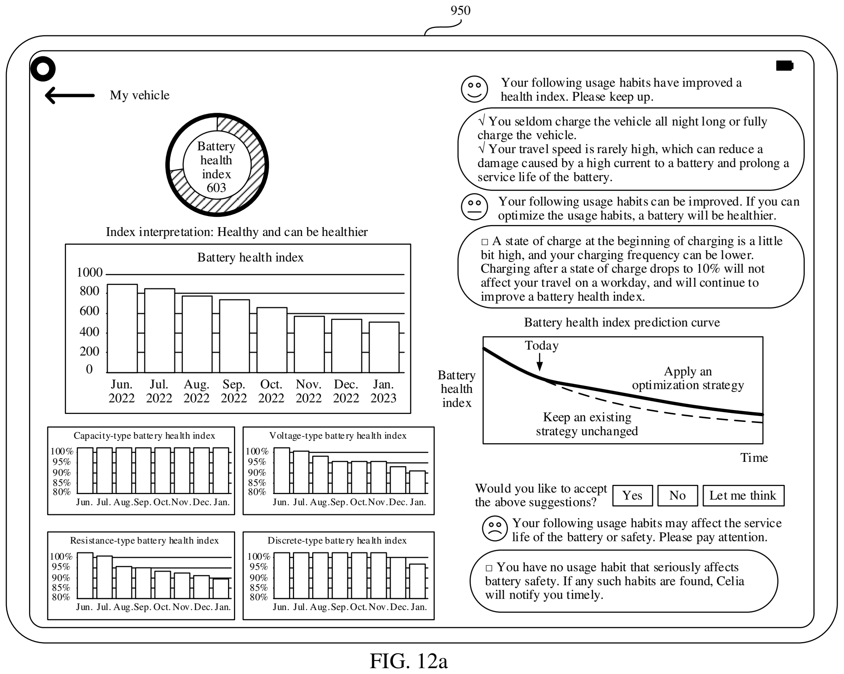

For another example, the cloud may also generate a battery health report of a target device and interpretation of the battery health report. For example, FIG. 12a is another interface diagram of a battery management method according to an embodiment of this application. FIG. 12a may also be displayed by using any device connected to the cloud. It can be learned from the interface 950 shown in FIG. 12a that the battery health report of the target device may include but is not limited to: a battery health index, interpretation of the battery health index, time trends of various battery health indexes, interpretation of usage habits based on battery health, strategy interaction feedback, and a battery health index prediction curve. The battery health index prediction curve may include a first prediction curve of a battery health index obtained when the target device keeps an existing strategy unchanged, and a second prediction curve of a battery health index obtained after the target device applies an optimization strategy. It can be learned from the interface 950 that an attenuation speed of the battery health index of the second prediction curve is slower than an attenuation speed of the battery health index of the first prediction curve, so that an attenuation speed of the battery state of health can be slowed down, and a battery service life can be extended.

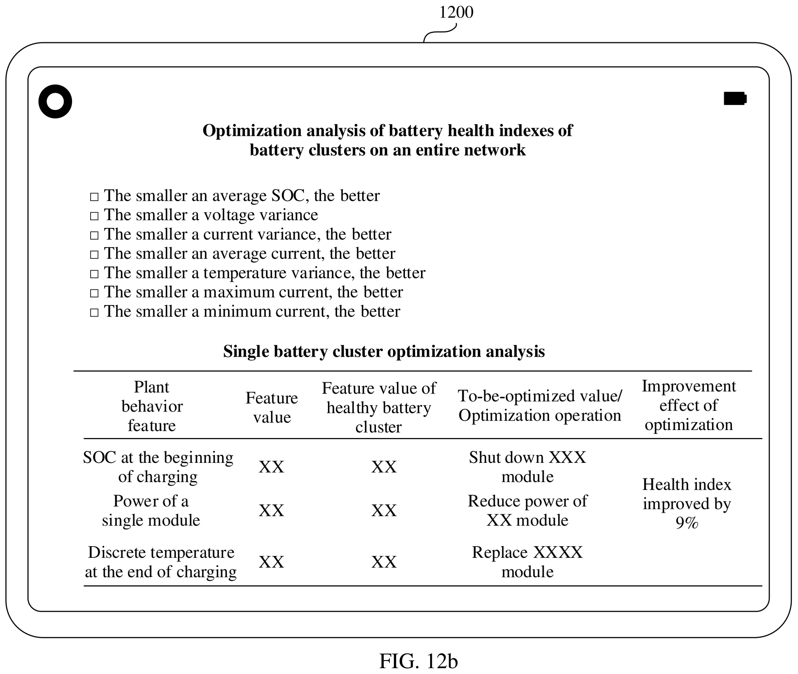

For another example, the cloud may also provide an optimization suggestion for the battery clusters on the entire network and/or a single battery cluster based on the battery health indexes of the battery clusters on the entire network and/or the various types of battery health indexes. FIG. 12b is another interface diagram of a battery management method according to an embodiment of this application. FIG. 12b may also be displayed by using any device connected to the cloud. It can be learned from an interface 1200 shown in FIG. 12b that, based on at least one of the battery health indexes of the battery clusters on the entire network and the various types of battery health indexes, an optimization suggestion corresponding to the battery clusters on the entire network may be further generated, or an optimization suggestion corresponding to a single battery cluster may be generated.

According to the foregoing example, in this embodiment of this application, a battery health management manner based on the obtained total battery health index and the various types of battery health indexes is not limited. For example, the battery health management manner may include but is not limited to a fault alarm and a battery optimization suggestion. In addition, analysis may be performed with reference to battery features at all levels, for example, basic battery features such as a current and a voltage, an aggregate feature obtained based on the basic battery features, the various types of battery health indexes, and the total battery health index. Further, battery health analysis results of all levels and a combined health analysis result of all levels are obtained, for example, an analysis result of an electrochemical cell, a battery module, or even a battery cluster is obtained. For another example, an analysis result of a battery module that affects the battery cluster and an analysis result of an electrochemical cell that affects the battery module are obtained. Specific battery management scenarios are not listed one by one in this application.

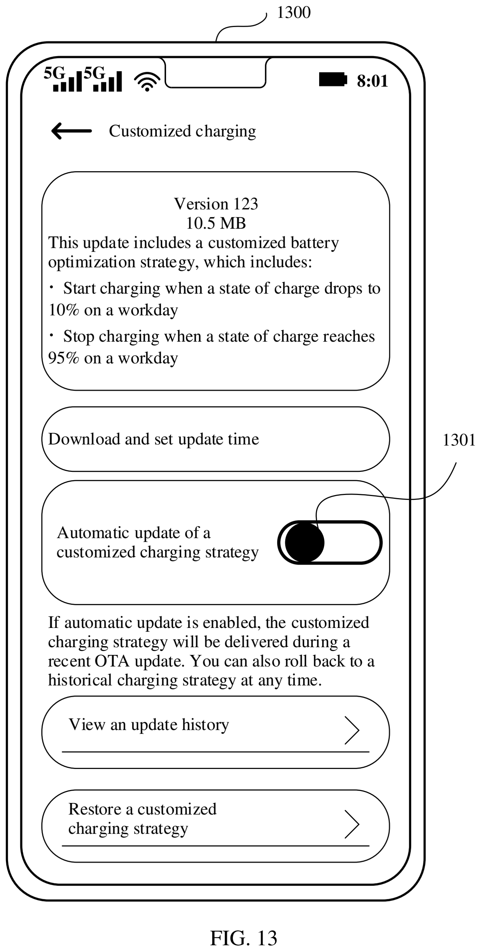

Further, the cloud may generate, for the target device, a battery management strategy used to perform battery management, for example, an optimization strategy indicated by the interface 950. For example, based on an over the air (over the air technology, OTA) upgrade technology, the cloud may send the battery management strategy to the target device. After detecting the battery management strategy from the cloud, the target device may apply the battery management strategy after receiving the battery management strategy, so that battery management can be performed based on the battery management strategy. For example, FIG. 13 is still another interface diagram of battery management according to an embodiment of this application. An interface 1300 shown in FIG. 13 is battery management for charging the target device. The interface 1300 may include but is not limited to the battery management strategy from the cloud, a "Download and set update time" control, an "Automatically update a customized charging strategy" control 1301, a "View an update history" control, and a "Restore a customized charging strategy" control. For example, the target device may automatically update the charging strategy by enabling the control 1301, so that automatic battery health management can be implemented, user operation complexity can be reduced, and a service life of the target device can be extended. It may be understood that the cloud may further generate a battery management strategy in another aspect. For an implementation, refer to an example of battery management in a charging aspect shown on the interface 1300. This is not specifically limited in this application.

It may be understood that the foregoing scenarios may be also combined with each other, and this application is not limited to the foregoing scenarios. In addition, a form in which the device displays the content related to battery management is not limited. For example, the form may be any manner such as a text, a graph, a voice, a video, or a pop-up window.

Based on the content described in the foregoing scenarios, according to the method provided in this embodiment of this application, the battery state of health of the device can be analyzed more comprehensively, so that the battery can be managed more timely, to reduce an attenuation speed of battery health and extend battery service life.

Based on the foregoing content that describes an interface processing effect that can be achieved according to the method provided in this embodiment of this application, the following describes an implementation process of the battery management method provided in this application, to describe how to achieve interface processing effects shown in FIG. 4A to FIG. 4D, FIG. 5a and FIG. 5b, FIG. 6, FIG. 7, FIG. 8a(1) and FIG. 8a(2) to FIG. 8c, FIG. 9, FIG. 10, FIG. 11a to FIG. 11c, FIG. 12a and FIG. 12b, and FIG. 13 according to the method provided in this application, so that battery management can be performed on the battery of the device, and a battery service life can be extended.

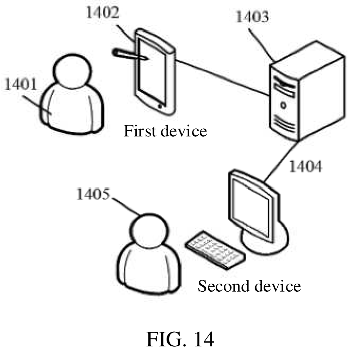

For example, the method provided in this embodiment of this application may be implemented based on software as a service (software as a service, SaaS). In some possible embodiments, FIG. 14 is a diagram of an application scenario of a battery management method according to an embodiment of this application. The application scenario may include a user 1401, a first device 1402, a cloud server 1403 (which may be, for example, the server 100b in the scenario shown in FIG. 2a), a second device 1404, and a user 1405. It should be noted that, although one first device 1402, one cloud server 1403, and one second device 1404 are shown in FIG. 14, a quantity and a type of the first device 1402 are not limited in this application, and a quantity and a type of the cloud server 1403 and the second device 1404 are not limited either. For example, the first device 1402 may be a device including a battery, such as a mobile phone, a tablet computer, or a new energy vehicle. The cloud server 1403 may also be a cloud server group. The cloud server group may include a plurality of servers. The second device 1404 may be a device having a display function, such as a computer or a tablet computer. The first device 1402 may be understood as a device on which battery management needs to be performed, and the user 1401 is a user who uses the first device 1402. The second device 1404 may be understood as a device used by a back-end technician, and the user 1405 is the back-end technician. The back-end technician may implement battery management, after-sales management, or the like on devices on an entire network or a target device by using the second device 1404. It should be noted that a connection relationship between the first device 1402 and the cloud server 1403 and a connection relationship between the cloud server 1403 and the second device 1404 are not limited in this embodiment of this application, for example, may be connected in a wired or wireless manner.

The following separately describes functions that can be implemented by the first device 1402, the cloud server 1403, and the second device 1404.
1. The first device 1402 may be configured to collect battery-related data. For example, the battery-related data may include but is not limited to user usage data such as a quantity of charging/discharging times and charging/discharging duration, a specific capacity in a battery charging/discharging process, and data such as a voltage status, a resistance status, and a stable status of a battery in a full life cycle. Optionally, the first device 1402 may upload the battery-related data to the cloud server 1403 based on the SaaS, receive a battery health report, an interpretation, a battery management strategy, and the like that are obtained after the cloud server 1403 performs battery health analysis, and display the battery health report, the interpretation, the battery management strategy, and the like to the user. Optionally, the first device 1402 may also analyze the battery-related data, to obtain a battery health report, an interpretation, a battery management strategy, and the like.

It should be noted that the first device 1402 may periodically report and collect battery-related data. For example, the first device 1402 may report collected battery-related data in a previous period to the cloud server 1403 at a specified time point every day. Alternatively, the first device 1402 may report collected battery-related data in real time.

2. The cloud server 1403 may be configured to: receive battery-related data from one or more devices, and analyze the battery-related data to obtain a battery health report, an interpretation, a battery management strategy, and the like of the first device 1402. In addition, the cloud server 1403 may be further configured to analyze battery states of health of devices on the entire network, to generate a battery management strategy for the first device 1402 based on technologies such as machine learning and hierarchical clustering.

In some embodiments, the battery health report may include a battery health index. The battery health index may be determined by using, but not limited to, one or a combination of the following indexes: a capacity-type battery health index, a voltage-type battery health index, a resistance-type battery health index, and a discrete-type battery health index.
(1) The capacity-type battery health index may be used to reflect a feature of a specific capacity in a battery charging process and/or a battery discharging process. For example, the capacity-type battery health index may be determined by using, but not limited to, one or a combination of the following information: a specific capacity in a battery charging process, a specific capacity in a battery discharging process, and an attenuation feature curve of the foregoing parameters in a battery life cycle. It may be understood that the capacity-type battery health index may be but is not limited to the maximum capacity 101 shown in FIG. 1, or a ratio of a maximum battery capacity to a corresponding nominal capacity, which may also be referred to as a battery state of health (state of health, SOH).
(2) The voltage-type battery health index may be used to reflect features of one or more of battery voltage parameters, such as an equilibrium electric potential, an average voltage, a platform voltage, a median voltage, a peak height in an incremental voltage curve, an integral area, and a voltage value corresponding to a peak position. For example, the voltage-type battery health index may be determined by using, but not limited to, one or a combination of the following information: an equilibrium electric potential, an average voltage, a platform voltage, a median voltage, a peak height in an incremental capacity curve, an integral area, a voltage value corresponding to a peak position, and an attenuation feature curve of the foregoing parameters in a battery life cycle.
(3) The resistance-type battery health index may be used to reflect features of one or more of resistance parameters such as a direct current resistance and a polarization resistance of a battery. For example, the resistance-type battery health index may be determined by using, but not limited to, one or a combination of the following information: a battery direct current internal resistance, a polarization internal resistance, and an attenuation feature curve of the foregoing parameters in a battery life cycle.
(4) The discrete-type battery health index is used to reflect features of one or more of parameters such as consistency of a voltage-type battery health index and a sub-index (for example, a feature for obtaining the voltage-type battery health index) of the voltage-type battery health index, consistency of a capacity-type battery health index and a sub-index (for example, a feature for obtaining the capacity-type battery health index) of the capacity-type battery health index, consistency of a resistance-type battery health index and a sub-index (for example, a feature for obtaining the resistance-type battery health index) of the resistance-type battery health index, voltage consistency, current consistency, temperature consistency, and force consistency. For example, the discrete-type battery health index may be determined by using, but not limited to, one or a combination of the following information: consistency of a voltage-type battery health index and a sub-index of the voltage-type battery health index, consistency of a capacity-type battery health index and a sub-index of the capacity-type battery health index, consistency of a resistance-type battery health index and a sub-index of the resistance-type battery health index, voltage consistency, current consistency, temperature consistency, force consistency, and an attenuation feature curve of the foregoing parameters in a battery life cycle. In addition, the discrete-type battery health index may not only reflect a discrete status of a single battery, but also reflect a discrete status of a plurality of batteries.

In this embodiment of this application, the battery health index may be obtained by performing weighted summation on various types of battery health indexes. Therefore, how to determine weight coefficients of the various types of battery health indexes is worth considering. The following describes several possible implementations of determining the weight coefficients.

**Implementation A:** Weights of the various types of battery health indexes described above may be determined in one or more manners such as an entropy weight method, maximum likelihood estimation, an expert system, and machine learning, so that the battery health index of the device may be determined in a manner such as weighted summation. Implementations of weight determining may be mainly classified into a subjective weighting method, an objective weighting method, and a subjective and objective comprehensive weighting method.
(1) The subjective weighting method may include, for example, an analytic hierarchy process and an expert judgment method. In a case of high-dimensional space, high coupling, or unclear mechanism, it is difficult for the subjective weighting method to provide accurate scales, and even systemic deviations may occur. Even if a weight is obtained through a large quantity of experiments and experience summaries, a generalization capability of a model may be poor.
(2) The objective weighting method may include, for example, an entropy weighting method, principal component analysis, a rough set, and a standard deviation method. However, the objective weighting method considers only a feature selection in a response target, but does not consider impact of a feature in a factor on a response.
(3) The subjective and objective comprehensive weighting method may include, for example, a combined weighting method of an analytic hierarchy process and an entropy weighting method. Construction methods include a variance maximization weighting method, an optimal coordination weighting method, a combined objective programming method, and a combined least square method. However, in many scenarios, a mathematical derivation and an expert scale of the subjective and objective comprehensive weighting method are too cumbersome, and generalization and operability are poor.

**Implementation B:** A plurality of possible feature factors may be constructed subjectively. For example, a feature may be constructed based on expert experience. A relationship between a feature factor and a response is quantized objectively. Finally, the relationship is converted into a weight coefficient optimization problem. By applying an optimization algorithm, an optimal weight combination of each feature in the response can be found. For example, the capacity-type battery health index, the voltage-type battery health index, the resistance-type battery health index, and the discrete-type battery health index may be used as constructed feature factors, and the battery health index may be used as a response. A weight system of each feature factor is determined by using the optimization algorithm, so that a more accurate response can be obtained. For another example, the various types of battery health indexes may also be used as responses. A capacity-type battery health index is used as an example, and a feature factor that affects the capacity-type battery health index may be constructed, for example, the specific capacity in the battery charging process, the specific capacity in the battery discharging process, and the attenuation feature curve of the foregoing parameters in the battery life cycle that are described in the foregoing embodiments. It should be understood that the feature factor and the response may be constructed in a multi-level manner. For example, the capacity-type battery health index is first used as a response to obtain the capacity-type battery health index, and then the capacity-type battery health index is used as a feature factor to further obtain the battery health index. Alternatively, the feature factor and the response may be directly constructed. For example, various battery-related parameters (for example, an equilibrium electric potential and an average voltage of a battery) are used as feature factors, to obtain the battery health index. A specific construction manner is not limited in this application.

Optionally, initial weight coefficients may be set for the various types of battery health indexes. Then, different weight combinations corresponding to the various types of battery health indexes are traversed to determine S weighted summation results, where S is a positive integer. A target weight combination is selected from the S weighted summation results. A sum of weight coefficients of the various types of battery health indexes is a preset value. For example, weights of the capacity-type battery health index, the voltage-type battery health index, the resistance-type battery health index, and the discrete-type battery health index are respectively represented as w1, w2, w3, and w4. For example, the relationship may be represented as w1+w2+w3+w4=1. An initial weight combination may be set to, for example, {w1, w2, w3, w4}={0.25, 0.25, 0.25, 0.25} or {w1, w2, w3, w4}={0.1, 0.1, 0.1, 0.7}. A traversal condition of the weight combination may be, for example, set to a step of 0.1. In addition, the target weight combination may be, for example, {w1, w2, w3, w4}={0.4, 0.3, 0.2, 0.1}. Based on the target weight combination, the battery health index 503 or the battery health index 504 shown in FIG. 5b may be displayed.

In the foregoing example, some model explanation methods may be used for feature factor quantization, for example, including but not limited to: a Shapley value-based explanation method (a model explanation method), a gradient-based explanation method, a local model-based explanation method, and a feature importance-based explanation method, an information gain-based explanation method, a model parameter-based explanation method, a model uncertainty-based explanation method, and the like. The model interpretation method may be used to explain a contribution degree of each feature factor to a response, and interaction between different feature factors may also be considered.

In the foregoing example, the feature factor may be selected based on profile data, for example, may be obtained based on information such as a user profile, an environment profile, a battery profile, a device profile, a power generation profile, a power grid profile, a carbon footprint profile, and a production profile. A feature factor selection method may include, for example, but is not limited to, the following methods: a filter method (filter method), a wrapper method (wrapper method), and an embedded method (embedded method). The filter method includes, for example, a Pearson correlation coefficient (Pearson correlation coefficient), chi-square (chi-square) verification, a mutual information and maximum information coefficient (mutual information and maximal information coefficient), and a variance selection method (variance threshold). The wrapper method includes, for example, forward feature selection (forward feature selection), backward feature selection (backward feature selection), and recursive feature elimination (recursive feature elimination). The embedded method includes, for example, penalty term-based feature selection and model-based feature selection.

In addition, the feature factor may further include a feature obtained through combination and crossing, for example, may include but is not limited to encoding nonlinearity (encoding nonlinearity) and a crossing one-hot vector (crossing one-hot vector). In addition, dimension reduction processing may be further performed on the feature factor, to avoid calculation repetition and redundancy. A dimension reduction method may include, for example, but is not limited to, a linear method (linear method) and a non-linear method (Nonlinear Methods). The linear method includes, for example, a principal component analysis (principal component analysis) method and a linear discriminant analysis (linear discriminant analysis) method. The non-linear method includes, for example, locally linear interpolation (locally linear coordination), a Laplacian eigen map (Laplacian eigen map), local tangent space alignment (local tangent space alignment), stochastic neighbor embedding (stochastic neighbor embedding), an automatic encoder (automatic encoder), multidimensional scaling (multidimensional scaling), isometric feature mapping (isometric feature mapping), and kernel principal component analysis (kernel PCA).

In the foregoing example, the target weight combination may be selected from the S weighted summation results by using, but not limited to, the following optimization methods: Bayesian optimization, genetic programming, reinforcement learning, and the like. Accuracy and efficiency of determining the weight coefficient can be improved by using the optimization algorithm. The optimization algorithm may further include but is not limited to the following types:

An evolutionary algorithm (evolutionary algorithm) type: a genetic algorithm (genetic algorithm), an evolution strategy (evolution strategy), differential evolution (differential evolution), simulated annealing (simulated annealing), a shuffled complex evolutionary programming (shuffled complex evolutionary programming, SCE-UA) algorithm, and the like.

A swarm intelligence (swarm intelligence) type: particle swarm optimization (particle swarm optimization), ant colony optimization (ant colony optimization), a fruit fly optimization algorithm (fruit fly optimization algorithm, FOA), a frog leaping algorithm (frog leaping algorithm, SFLA), cockroach swarm optimization (cockroach swarm optimization), and the like.

A gradient-based optimization (gradient-based optimization) type: gradient descent (gradient descent), Newton's method (Newton's method), a quasi-Newton method (quasi-Newton method), a conjugate gradient (conjugate gradient) method, and the like.

A constraint optimization (constraint optimization) type: a Lagrange multiplier (Lagrange multiplier), a penalty function method (penalty function method), and a projection method (projection method).

Another optimization method type: simulated annealing (simulated annealing), genetic simulated annealing (genetic simulated annealing), genetic gradient optimization (genetic gradient optimization), an artificial bee colony algorithm (artificial bee colony algorithm), an artificial fish swarm algorithm (artificial fish swarm algorithm), genetic particle swarm optimization (genetic particle swarm optimization), a genetic evolution strategy (genetic evolution strategy), genetic differential evolution (genetic differential evolution), and a tabu search (tabu search) algorithm.

In addition, it should be noted that the weight system determining method provided in Implementation B may be applied to the battery field, and index construction in various fields, for example, a total quality index, a total vehicle motor health index, and a total vehicle electronic health index. For index construction in another field, refer to the description content in this embodiment of this application. Details are not described in this application again.

In some other embodiments, the battery health report may further include the aging rate information of the battery health index, for example, information shown in FIG. 6. For example, the aging rate information may be obtained through calculation by using a plurality of battery health indexes. It may be understood that the aging rate information may be used to reflect the attenuation speed of the battery health index. For another example, the battery health report may further include but is not limited to one or a combination of the following information: aging rate information of the capacity-type battery health index, aging rate information of the voltage-type battery health index, aging rate information of the resistance-type battery health index, and aging rate information of the discrete-type battery health index.

In some embodiments, the cloud server 1403 may interpret the battery state of health of the first device 1402 based on the battery health index and the aging rate information of the battery health index. For example, the cloud server 1403 may match an interpretation result based on the following Table 1.

**Table 1**

| **Battery health report** | **Interpretation result** |
|---|---|
| High health index score + High health index aging rate | The battery is in good condition. Your battery can be healthier |
| High health index score + Low health index aging rate | The battery state of health is very good. Keep up with your good habits. |
| Medium health index score + High health index aging rate | Pay attention to the battery state of health. Check out the battery health strategy customized for you. |
| Medium health index score + Low health index aging rate | Pay attention to the battery state of health. Go to a 4s store or contact an after-sales service personnel. |
| Low health index score + High health index aging rate | The battery state of health is unsatisfactory. Check out more healthy usage habits. |
| Low health index score + Low health index aging rate | The battery state of health is unsatisfactory. We will contact you as soon as possible. |

It can be learned from Table 1 that a corresponding interpretation result may be obtained based on an obtained battery health report. It should be noted that the interpretation result shown in Table 1 is merely a possible example, and may be pre-stored in the cloud server 1403, or may be stored in the first device 1402. The first device 1402 interprets the battery health report to obtain the interpretation result.

In some other embodiments, the cloud server 1403 may further extract, through machine learning based on battery-related data collected by the first device 1402, a feature parameter that affects the battery health index of the first device 1402. The feature parameter may include, for example, a usage habit of the first device 1402 by the user 1401. Then, the cloud server 1403 may match a corresponding interpretation report based on the feature parameter, for example, the interpretation report shown on the interface 910 in FIG. 9. The interpretation report may include but is not limited to a healthy habit, an optimizable habit, a habit that needs to be optimized urgently, and the like.

It should be noted that, that the cloud server 1403 interprets the battery state of health of the first device 1402 may be implemented as interpreting the battery state of health of the first device 1402 based on the battery data of the first device 1402, or may be implemented as interpreting the battery state of health of the first device 1402 based on battery data of the devices on the entire network, or may be implemented as interpreting the battery state of health of the first device 1402 based on battery data of a plurality of devices that meet a preset condition, where the preset condition may be, for example, devices belonging to a same cluster or a same category. For example, the healthy habit interpreted by the cloud server 1403 may be, for example, an existing habit of the first device 1402, or may be a habit that can be learned and that is obtained through analysis based on the devices on the entire network or the plurality of devices that meet the preset condition.

In some embodiments, the cloud server 1403 may perform cluster analysis or classification on the devices on the entire network based on hierarchical clustering or classification of the battery-related data of the devices on the entire network. Then, the cloud server 1403 may obtain the battery management strategy of the first device 1402 based on battery-related data of target devices in a same cluster or a same category. The target device may be, for example, one or more devices whose battery health index is greater than a specified index threshold, for example, may be a device with a highest battery health index. For example, the cloud server 1403 may perform analysis based on profile features such as a user profile, an environment profile, a battery profile, a device profile, power generation profile data, power grid profile data, carbon footprint profile data, and production profile data, to obtain different clusters or different categories. The user profile data, the environment profile data, the battery profile data, and the device profile data are concerned features in the field of vehicle-mounted and 3C electronic products (such as a mobile phone, a tablet, and a notebook computer). The user profile data, the environment profile data, the battery profile data, the device profile data, the power generation profile data, the power grid profile data, the carbon footprint profile data, and the production profile data are concerned features in the energy storage field (such as a user scenario, a commercial and industrial industry scenario, a utility-scale scenario, a data center scenario, and a site energy scenario). It may be understood that devices having a same or similar profile feature may be classified into a same cluster or category. Optionally, a device with a high battery health index in a same cluster or category may be used as the target device, a device with a low battery health index may be used as the first device 1402, and the battery management strategy of the first device 1402 may be generated based on the battery management strategy of the target device. In this way, the battery state of health of the first device 1402 may be improved based on the changed battery management strategy. This may also be understood as that the aging rate of the battery state of health of the first device 1402 is reduced.

**In** some possible embodiments, that the battery management strategy of the first device 1402 may be generated based on the battery management strategy of the target device may be implemented as using the battery management strategy of the target device as the target battery management strategy of the first device 1402. In some other possible embodiments, the battery management strategy of the first device 1402 may be generated based on the battery management strategy of the target device, or may be implemented as adaptively generating or adjusting the target battery management strategy of the first device based on the battery management strategy of the target device.

Alternatively, optionally, the cloud server 1403 may further perform feature analysis on battery data of all devices included in a same cluster or category, to obtain a target battery management strategy of the cluster or category. It may be understood that the target battery management strategy of the cluster or category is used to improve a battery state of health of each device. In this way, each device in the cluster or category may apply the target battery management strategy of the cluster or category, so that the aging rate of the battery state of health of the first device 1402 can be reduced.

**In** some other embodiments, the cloud server 1403 may also generate a globally optimal usage strategy based on the battery data of the devices on the entire network, and then generates the battery management strategy of the first device based on a clustering condition or a classification condition and an optimization strategy knowledge graph. Alternatively, the battery management strategy of the first device 1402 may be obtained based on the battery-related data of the devices on the entire network. In this way, the cloud server 1403 may perform statistical analysis on the battery-related data of the devices on the entire network, to obtain a more comprehensive battery management strategy.

In some possible embodiments, the cloud server 1403 may generate the target battery management strategy of the first device based on the user profile data. This may be implemented as follows: The server generates at least one battery management strategy in at least one preset manner, and determines the target battery management strategy from the at least one battery management strategy based on the user profile data. In this way, the server may select, for the user, a battery management strategy that can better match a preference of the user, so that user experience can be improved. The preset manner may be the battery management strategy obtained in a manner described above like, for example, obtaining the usage strategy of the target device based on the clustering method or classification method; obtaining the usage strategy of the target device according to different clustering methods or classification methods, and generating the local optimal usage strategy in combination with the usage strategy of M groups of battery data; and generating the global optimal usage strategy based on the usage strategy of the M groups of battery data, and then generating the locally optimal usage strategy based on the clustering condition or classification condition and the optimization strategy knowledge graph. Then, the cloud server 1403 obtains the target battery management strategy of the first device from the at least one battery management strategy based on the user profile data.

A user preference is analyzed based on the user profile data, where the user preference includes but is not limited to: a preference of the user for battery usage, a preference for a customized battery strategy, an acceptance degree of a new thing, a preference for device usage, and the like.

In addition, in some other possible embodiments, the user profile data may alternatively be updated in real time, and a composition source includes but is not limited to original cloud data and user feedback data. For example, the server receives at least one of user feedback data and device feedback data that are sent by the M devices, where the user feedback data indicates a user feedback behavior related to the battery analysis result, and the device feedback data indicates device collection information related to the battery analysis result, updates the user profile data based on at least one of the user feedback data and the device feedback data, and updates and determines the target battery management strategy from the at least one battery management strategy based on updated user profile data.

A data source of the user feedback data may include but is not limited to user end data and remote after-sales end data. The user end data may originate from a strategy interaction feedback, including but not limited to: stay time of the user on a corresponding interface, a status of enabling an optimization strategy switch by a user, a status of degrading/withdrawing an optimization strategy by a user, feedback information (including but not limited to a text and a voice) output by a user at an interaction entry like the "I have something to say" control shown on the interface 910 in FIG. 9 or any location on an interface, or information (including but not limited to a text, a voice, a scrolling comment, a picture, and a video) published, liked, added to favorites, or reprinted in a corresponding community module. The remote after-sales end data may originate from, including but not limited to, a manual customer service feedback module (including but not limited to a phone call, a text message, an email, an after-sales record, and the like), information (including but not limited to a text, a voice, and the like) output by an interaction entry at any location on an interface; information (including but not limited to a text, a voice, a scrolling comment, a picture, and a video) posted, liked, added to favorites, or reprinted by a user in the corresponding community module, analysis of a user's historical stay duration on a corresponding interface, analysis of a user's historical feedback on a battery health strategy, analysis of a user's historical acceptance of a battery optimization strategy, analysis of a user's behavior change after the user accepts a strategy, and a knowledge graph of a user profile and strategy optimization.

Further, after obtaining the battery management strategy of the first device 1402, the cloud server 1403 may deliver the battery management strategy to the first device 1402 based on an OTA upgrade technology. For example, as shown on the interface 1300 in FIG. 13, the first device 1402 may configure a manner of receiving the battery management strategy. When the receiving manner is automatic update, the first device 1402 may automatically download an OTA upgrade package including a changed battery management strategy, and apply the changed battery management strategy included in the OTA upgrade package.

3. The second device 1404 is configured to obtain the battery health reports of the devices on the entire network or a battery health report of a specified device from the cloud server 1403 in response to a user operation of the user 1405. For example, the interface 930 shown in FIG. 11a is an example diagram in which the second device 1404 displays the battery health reports of the devices on the entire network, and the interface 950 shown in FIG. 12a is an example in which the second device 1404 displays a battery health report of a specified device. For example, the specified device may be a new energy vehicle of Zhang San. It may be understood that the user 1405 may perform more accurate and timely battery management based on the battery health report shown by the second device 1404. For example, an OTA upgrade package may be delivered to a specified device, where the OTA upgrade package includes a changed battery management strategy and the like.

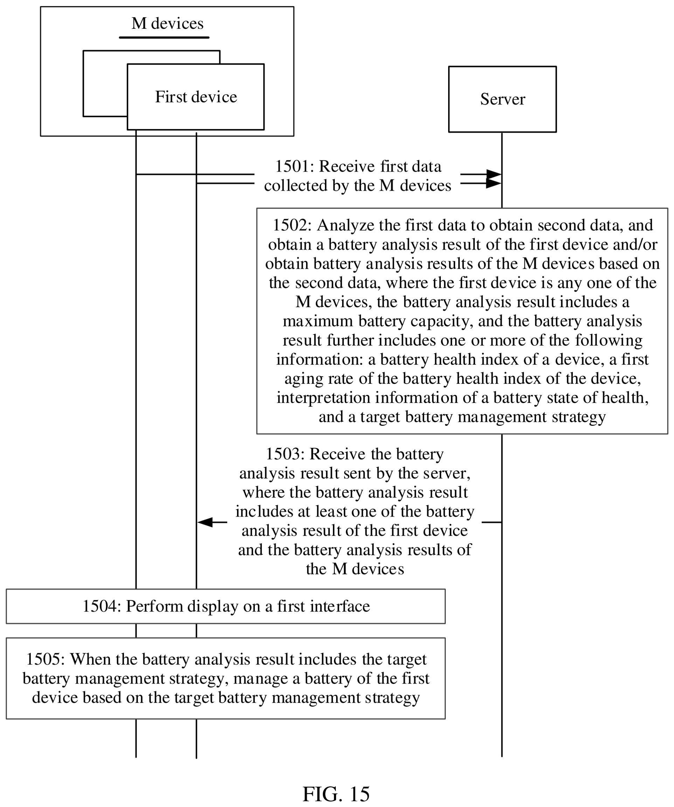

FIG. 15 is a schematic flowchart of a battery management method according to an embodiment of this application. A procedure may include the following steps.

Step 1501: A server receives first data collected by M devices.

Step 1502: The server analyzes the first data to obtain second data, and obtains a battery analysis result of a first device and/or obtains battery analysis results of the M devices based on the second data, where the first device is any one of the M devices, the battery analysis result includes a maximum battery capacity, and the battery analysis result further includes one or more of the following information: a battery health index of a device, a first aging rate of the battery health index of the device, interpretation information of a battery state of health, and a target battery management strategy.

The battery health index of the device is calculated based on at least one of a capacity-type battery health index, a voltage-type battery health index, a resistance-type battery health index, or a discrete-type battery health index included in the second data, for example, the battery health index 404 shown on the interface 440, the battery health index 501 or the battery health index 502 shown in FIG. 5a, or the battery health index 503 or the battery health index 504 shown in FIG. 5b, and the various types of battery health indexes shown in FIG. 7.

The first aging rate of the battery health index of the device indicates an attenuation speed of the battery health index of the device, for example, the aging rate information 601 of the battery health index or the aging rate information 602 of the battery health index shown in FIG. 6. For another example, the content shown in FIG. 7 may also indirectly indicate the aging rate information of the battery health index.

The interpretation information of the battery state of health indicates a user behavior factor that affects the battery health index of the device and the first aging rate, for example, the interface 460 shown in FIG. 8a(2), the interface 470 and the interface 480 shown in FIG. 8b(2) and FIG. 8b(3), the interface 910 shown in FIG. 9, or the interface 920 shown in FIG. 10.

The target battery management strategy is obtained based on at least one of the battery health index of the device and the first aging rate, and is used to update the first aging rate to a second aging rate, where the second aging rate is less than the first aging rate, for example, the interface 1300 shown in FIG. 13.

Step 1503: The first device receives the battery analysis result sent by the server, where the battery analysis result includes at least one of the battery analysis result of the first device and the battery analysis results of the M devices.

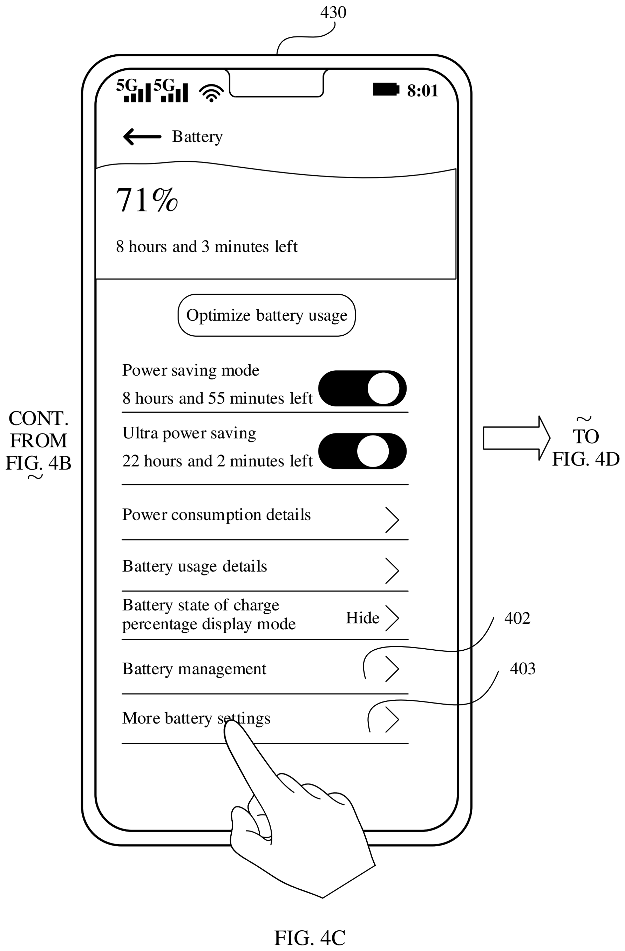

Step 1504: The first device performs display on a first interface. In some possible embodiments, the first device may detect a first operation, for example, a user operation such as a tap operation or a touch and hold operation on the battery management 402 or more battery devices 403 shown on the interface 430 in FIG. 4C. Then, the first device displays the first interface in response to the first operation, where the first interface includes the battery analysis result. For example, the first interface may be, for example, the interface 440 in FIG. 4D, the interface 930 in FIG. 11a, or the interface 950 in FIG. 12a.

Step 1505: When the battery analysis result includes the target battery management strategy, the first device manages a battery of the first device based on the target battery management strategy.

For a specific implementation, refer to description content corresponding to FIG. 4A to FIG. 4D, FIG. 5a and FIG. 5b, FIG. 6, FIG. 7, FIG. 8a(1) and FIG. 8a(2) to FIG. 8c, FIG. 9, FIG. 10, FIG. 11a to FIG. 11c, FIG. 12a and FIG. 12b, FIG. 13, and FIG. 14. Details are not described herein again.

Based on the foregoing embodiments, this application further provides a device. The device includes a plurality of functional modules. The plurality of functional modules interact with each other to implement functions performed by the device in the methods described in embodiments of this application. The plurality of functional modules may be implemented based on software, hardware, or a combination of software and hardware, and the plurality of functional modules may be randomly combined or divided based on specific implementation. For example, steps 1501 and 1503 to 1505 performed by the device in the embodiment shown in FIG. 15 are performed.

Based on the foregoing embodiments, this application further provides a device. The device includes at least one processor and at least one memory. The at least one memory stores computer program instructions. When the device runs, the at least one processor performs the methods described in embodiments of this application. For example, steps 1501 and 1503 to 1505 performed by the device in the embodiment shown in FIG. 15 are performed.

Based on the foregoing embodiments, this application further provides a computer program product. The computer program product includes a computer program (which may also be referred to as code or instructions). When the computer program is run, the methods described in embodiments of this application are performed.

Based on the foregoing embodiments, this application further provides a computer-readable storage medium. The computer-readable storage medium stores a computer program (which may also be referred to as code or instructions). When the code or instructions are executed by a computer, the computer is enabled to perform the methods described in embodiments of this application.

Based on the foregoing embodiments, this application further provides a chip. The chip is configured to read a computer program stored in a memory, to implement the methods described in embodiments of this application.

Based on the foregoing embodiments, this application provides a chip system. The chip system includes a processor, configured to support a computer apparatus in implementing the methods described in embodiments of this application. In a possible design, the chip system further includes a memory, and the memory is configured to store a program and data that are necessary for the computer apparatus. The chip system may include a chip, or may include a chip and another discrete component. A person skilled in the art should understand that embodiments of this application may be provided as a method, a system, or a computer program product. Therefore, this application may use a form of hardware only embodiments, software only embodiments, or embodiments with a combination of software and hardware. In addition, this application may use a form of a computer program product that is implemented on one or more computer-usable storage media (including but not limited to a disk memory, a CD-ROM, an optical memory, and the like) that include computer-usable program code.

According to the context, the term "when" or "after" used in the foregoing embodiments may be interpreted as a meaning of "if" or "after" or "in response to determining" or "in response to detecting". Similarly, according to the context, the phrase "when it is determined that" or "if (a stated condition or event) is detected" may be interpreted as a meaning of "if it is determined that", "in response to determining", "when (a stated condition or event) is detected", or "in response to detecting (a stated condition or event)".

This application is described with reference to the flowcharts and/or block diagrams of the method, the device (system), and the computer program product according to this application. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specific function in one or more processes in the flowcharts and/or in one or more blocks in the block diagrams.

These computer program instructions may be stored in a computer-readable memory that can instruct the computer or any other programmable data processing device to work in a specific manner, so that the instructions stored in the computer-readable memory generate an artifact that includes an instruction apparatus. The instruction apparatus implements a specific function in one or more processes in the flowcharts and/or in one or more blocks in the block diagrams.

The computer program instructions may alternatively be loaded onto a computer or another programmable data processing device, so that a series of operations and steps are performed on the computer or the another programmable device, so that computer-implemented processing is generated. Therefore, the instructions executed on the computer or the another programmable device provide steps for implementing a specific function in one or more procedures in the flowcharts and/or in one or more blocks in the block diagrams.

It is clear that persons skilled in the art can make various modifications and variations to this application without departing from the protection scope of this application. This application is intended to cover these modifications and variations of this application provided that they fall within the scope of protection defined by the following claims and their equivalent technologies.

## Claims

1. A battery management system, comprising M devices and a server, wherein M is a positive integer, wherein
the server is configured to separately receive first data collected by the M devices;
the server is further configured to: analyze the first data to obtain second data, and obtain a battery analysis result of a first device and/or obtain battery analysis results of the M devices based on the second data, wherein the first device is any one of the M devices, wherein
the battery analysis result comprises a maximum battery capacity, and the battery analysis result further comprises one or more of the following information:
a battery health index of a device, wherein the battery health index of the device is calculated based on at least one of a capacity-type battery health index, a voltage-type battery health index, a resistance-type battery health index, or a discrete-type battery health index comprised in the second data;
a first aging rate of the battery health index of the device, indicating an attenuation speed of the battery health index of the device;
interpretation information of a battery state of health, indicating a user behavior factor that affects the battery health index of the device and the first aging rate;
a target battery management strategy, wherein the target battery management strategy is obtained based on at least one of the battery health index of the device and the first aging rate, and is used to update the first aging rate to a second aging rate, and the second aging rate is less than the first aging rate; and
composition of the battery health index of the device, wherein the composition comprises at least one of the capacity-type battery health index, the voltage-type battery health index, the resistance-type battery health index, and the discrete-type battery health index; and
the first device is configured to: receive the battery analysis result sent by the server, and display the battery analysis result on a first interface, wherein the battery analysis result comprises at least one of the battery analysis result of the first device or the battery analysis results of the M devices.

2. The system according to claim 1, wherein the first data comprises data of the first device, and the data of the first device comprises at least one of the following data content:
battery physical data collected by the first device;
first user behavior data that is collected by the first device on the first interface and that is related to battery management performed by the first device;
second user behavior data that is collected by a second device on a second interface and that is related to battery management performed by the first device, wherein the second interface is used to display the battery analysis result of the first device;
third user behavior data that is collected by a third device on a third interface and that is related to battery management performed by the first device, wherein the third interface is used to display the battery analysis results of the M devices; and
fourth user behavior data that is obtained by the server through analysis and that is related to battery management performed by the first device.

3. The system according to claim 1 or 2, wherein the first device is used in a vehicle comprising a battery, and the battery analysis result indicates an analysis result of the battery of the vehicle; or
the first device is used in an energy storage device comprising an energy storage battery, and the battery analysis result is an analysis result of the energy storage battery; or
the first device is a mobile phone, a tablet computer, or a notebook computer, and the battery analysis result is an analysis result of the energy storage battery.

4. The system according to any one of claims 1 to 3, wherein the second data further comprises one or more of the following information:
user profile data, environment profile data, battery profile data, device profile data, power generation profile data, power grid profile data, carbon footprint profile data, and a production profile.

5. The system according to claim 4, wherein
the second device is configured to: receive the second data sent by the server, and display the second data on a fourth interface, wherein the second device is any device that is in the M devices and that is different from the first device.

6. The system according to claim 4 or 5, wherein when the second data comprises the user profile data,
that the server is configured to obtain the target battery management strategy comprises:
generating at least one battery management strategy in at least one preset manner; and
determining the target battery management strategy from the at least one battery management strategy based on the user profile data.

7. The system according to claim 6, wherein the at least one preset manner comprises a first preset manner; and
that the server is configured to generate the at least one battery management strategy in the first preset manner comprises:
clustering or classifying the M devices based on the first data;
determining N devices that belong to a same cluster or category as the first device, wherein N is a positive integer;
determining, from the N devices, a target device whose battery analysis result meets a preset condition; and
generating a target battery management strategy of the first device based on a battery management strategy of the target device.

8. The system according to claim 6 or 7, wherein
the first device is further configured to collect user feedback data on the first interface, and/or the first device is further configured to collect device feedback data, wherein the user feedback data indicates a user behavior related to the battery analysis result, and the device feedback data indicates device collection information related to the battery analysis result;
the server is further configured to: receive at least one of the user feedback data and the device feedback data that are sent by the first device, and update the user profile data in response to the at least one of the user feedback data and the device feedback data; and
the server is further configured to: update and determine the target battery management strategy from the at least one battery management strategy based on updated user profile data.

9. The system according to any one of claims 1 to 8, wherein the interpretation information of the battery state of health indicates a user behavior factor that affects a battery health index and a first aging rate of the first device and the battery health index and the first aging rate of the device; or
the interpretation information of the battery state of health indicates a user behavior factor that affects a battery health index and a first aging rate of a type of device that belongs to the same cluster or category as the first device and the battery health index and the first aging rate of the device, wherein the type of device that belongs to the same cluster or category as the first device is determined based on one or more of the following information: user profile data, environment profile data, battery profile data, device profile data, power generation profile data, carbon footprint profile data, and production profile data.

10. The system according to any one of claims 1 to 9, wherein the user behavior factor comprises at least one of a first type of user behavior factor, a second type of user behavior factor, and a third type of user behavior factor, wherein
the first type of behavior factor indicates a user behavior factor that has a first level of impact on the aging rate, wherein the first level of impact is less than a preset level of impact threshold;
the second type of user behavior factor indicates a user behavior factor that has a second level of impact on the aging rate, wherein the first level of impact is less than the second level of impact; and
the third type of user behavior factor indicates a user behavior factor that has a third level of impact on the aging rate, wherein the second level of impact is less than the third level of impact.

11. The system according to claim 10, wherein a threshold range is set for the battery health index of the first device.

12. The system according to any one of claims 1 to 11, wherein the first device is further configured to:
when the battery analysis result comprises the target battery management strategy, manage a battery of the first device based on the target battery management strategy.

13. The system according to claim 12, wherein the battery analysis result comprises the target battery management strategy; and
before managing the battery of the first device based on the target battery management strategy, the first device is further configured to:
detect a first operation, wherein the first operation indicates to apply the target battery management strategy, the first operation comprises a user operation on a first control or detecting that the first device meets a first preset condition, and the first preset condition comprises that the first device obtains an updated target battery management strategy, or the first device detects at least one of a preset application moment or a preset application condition; and
download and apply the target battery management strategy in response to the first operation.

14. The system according to any one of claims 1 to 13, wherein the battery analysis result further comprises prediction information, and the prediction information indicates at least one of the predicted battery health index of the device and the second aging rate predicted based on the target battery management strategy.

15. The system according to any one of claims 1 to 14, wherein the first device is further configured to:
detect a second operation on first information comprised in the battery analysis result on the first interface, wherein the first information indicates preview information of the battery health index of the device, preview information of the first aging rate, preview information of the interpretation information of the battery state of health, or preview information of the target battery management strategy; and
display a fifth interface in response to the second operation, wherein the fifth interface indicates detailed information corresponding to the first information.

16. The system according to any one of claims 1 to 15, wherein the first device is further configured to:
detect a fourth operation on the composition of the battery health index of the device; and
display a sixth interface in response to the fourth operation, wherein the sixth interface indicates interpretation information of the composition of the battery health index of the device.

17. The system according to any one of claims 1 to 16, wherein when the battery analysis result comprises the battery analysis results of the M devices, the first interface further comprises one or more of the following information:
distribution information of the battery analysis results of the M devices; and
ranking information of the battery analysis results of the M devices.

18. The system according to claim 17, wherein the first device or the server is further configured to:
send prompt information to at least one device based on the battery analysis results of the M devices, wherein the at least one device is a device whose battery state of health meets a preset state of health, and the prompt information indicates the battery state of health corresponding to the device.

19. The system according to any one of claims 1 to 18, wherein the aging rate information comprises battery health indexes of a plurality of devices within a preset time range, or battery health indexes of devices after a preset quantity of times.

20. The system according to any one of claims 1 to 19, wherein the battery health index of the device is displayed in one or a combination of the following forms: graph, table, text, and voice; and
the battery health index is between a first preset index and a second preset index, and the first preset index is less than the second preset index.

21. The system according to any one of claims 1 to 20, wherein the battery analysis result comprises at least one of the following battery types: electrochemical cell, battery module, battery pack, or battery cluster.

22. A battery management method, applied to a first device and comprising:
detecting a first operation, wherein the first operation is used to display a battery analysis result; and
displaying a first interface in response to the first operation, wherein the first interface comprises the battery analysis result, wherein
the battery analysis result comprises a maximum battery capacity, and the battery analysis result further comprises one or more of the following information:
a battery health index of a device, wherein the battery health index of the device is calculated based on at least one of a capacity-type battery health index, a voltage-type battery health index, a resistance-type battery health index, or a discrete-type battery health index;
a first aging rate of the battery health index of the device, indicating an attenuation speed of the battery health index of the device;
interpretation information of a battery state of health, indicating a user behavior factor that affects the battery health index of the device and the first aging rate;
a target battery management strategy, wherein the target battery management strategy is obtained based on at least one of the battery health index of the device and the first aging rate, and is used to update the first aging rate to a second aging rate, and the second aging rate is less than the first aging rate; and
composition of the battery health index of the device, wherein the composition comprises at least one of the capacity-type battery health index, the voltage-type battery health index, the resistance-type battery health index, and the discrete-type battery health index.

23. The method according to claim 22, wherein before the displaying the first interface, the method further comprises:
collecting first data, wherein the first data comprises at least one of the following data content: battery physical data collected by the first device; first user behavior data that is collected by the first device on the first interface and that is related to battery management performed by the first device; second user behavior data that is collected by a second device on a second interface and that is related to battery management performed by the first device, wherein the second interface is used to display the battery analysis result of the first device; third user behavior data that is collected by a third device on a third interface and that is related to battery management performed by the first device, wherein the third interface is used to display the battery analysis results of the M devices; and fourth user behavior data that is obtained by the server through analysis and that is related to battery management performed by the first device;
sending the first data to the server; and
receiving the battery analysis result from the server.

24. The method according to claim 22 or 23, wherein the first device is used in a vehicle comprising a battery, and the battery analysis result indicates an analysis result of the battery of the vehicle; or
the first device is used in an energy storage device comprising an energy storage battery, and the battery analysis result is an analysis result of the energy storage battery; or
the first device is a mobile phone, a tablet computer, or a notebook computer, and the battery analysis result is an analysis result of the energy storage battery.

25. The method according to any one of claims 22 to 24, wherein the method further comprises:
collecting user feedback data on the first interface, wherein the user feedback data indicates a user behavior related to the battery analysis result; and/or
collecting device feedback data on the first interface, wherein the device feedback data indicates device collection information related to the battery analysis result.

26. The method according to any one of claims 22 to 25, wherein the method further comprises:
when the battery analysis result comprises the target battery management strategy, managing a battery of the first device based on the target battery management strategy.

27. The method according to claim 26, wherein the battery analysis result comprises the target battery management strategy, and the method further comprises:
before managing the battery of the first device based on the target battery management strategy, further configured to:
detecting a first operation, wherein the first operation indicates to apply the target battery management strategy, the first operation comprises a user operation on a first control or detecting that the first device meets a first preset condition, and the first preset condition comprises that the first device obtains an updated target battery management strategy, or the first device detects at least one of a preset application moment or a preset application condition; and
downloading and applying the target battery management strategy in response to the first operation.

28. The method according to any one of claims 22 to 27, wherein the method further comprises:
detecting a second operation on first information comprised in the battery analysis result on the first interface, wherein the first information indicates preview information of the battery health index of the device, preview information of the first aging rate, preview information of the interpretation information of the battery state of health, or preview information of the target battery management strategy; and
displaying a fifth interface in response to the second operation, wherein the fifth interface indicates detailed information corresponding to the first information.

29. The method according to any one of claims 22 to 28, wherein the method further comprises:
detecting a fourth operation on the composition of the battery health index of the device; and
displaying a sixth interface in response to the fourth operation, wherein the sixth interface indicates interpretation information of the composition of the battery health index of the device.

30. A battery management method, comprising:
receiving, by a server, first data collected by the M devices;
analyzing, by the server, the first data to obtain second data; and obtaining a battery analysis result of a first device and/or obtaining battery analysis results of the M devices based on the second data, wherein the first device is any one of the M devices, wherein
the battery analysis result comprises a maximum battery capacity, and the battery analysis result further comprises one or more of the following information:
a battery health index of a device, wherein the battery health index of the device is calculated based on at least one of a capacity-type battery health index, a voltage-type battery health index, a resistance-type battery health index, or a discrete-type battery health index comprised in the second data;
a first aging rate of the battery health index of the device, indicating an attenuation speed of the battery health index of the device;
interpretation information of a battery state of health, indicating a user behavior factor that affects the battery health index of the device and the first aging rate;
a target battery management strategy, wherein the target battery management strategy is obtained based on at least one of the battery health index of the device and the first aging rate, and is used to update the first aging rate to a second aging rate, and the second aging rate is less than the first aging rate; and
composition of the battery health index of the device, wherein the composition comprises at least one of the capacity-type battery health index, the voltage-type battery health index, the resistance-type battery health index, and the discrete-type battery health index; and
sending, by the server, the battery analysis result to the first device, wherein the battery analysis result comprises at least one of the battery analysis result of the first device or the battery analysis results of the M devices.

31. The method according to claim 30, wherein the first data comprises data of the first device, and the data of the first device comprises at least one of the following data content:
battery physical data collected by the first device;
first user behavior data that is collected by the first device on the first interface and that is related to battery management performed by the first device;
second user behavior data that is collected by a second device on a second interface and that is related to battery management performed by the first device, wherein the second interface is used to display the battery analysis result of the first device;
third user behavior data that is collected by a third device on a third interface and that is related to battery management performed by the first device, wherein the third interface is used to display the battery analysis results of the M devices; and
fourth user behavior data that is obtained by the server through analysis and that is related to battery management performed by the first device.

32. The method according to claim 30 or 31, wherein the second data further comprises one or more of the following information:
user profile data, environment profile data, battery profile data, device profile data, power generation profile data, power grid profile data, carbon footprint profile data, and a production profile.

33. The method according to claim 30 or 31, wherein when the second data comprises the user profile data, and the battery analysis result comprises the target battery management strategy,
obtaining the target battery management strategy comprises:
generating at least one battery management strategy in at least one preset manner; and
determining the target battery management strategy from the at least one battery management strategy based on the user profile data.

34. The method according to claim 33, wherein the at least one preset manner comprises a first preset manner; and
generating the at least one battery management strategy in the first preset manner comprises:
clustering or classifying the M devices based on the first data;
determining N devices that belong to a same cluster or category as the first device, wherein N is a positive integer;
determining, from the N devices, a target device whose battery analysis result meets a preset condition; and
generating a target battery management strategy of the first device based on a battery management strategy of the target device.

35. The method according to claim 33 or 34, wherein the method further comprises:
receiving at least one of the user feedback data and the device feedback data that are sent by the first device, and updating the user profile data in response to the at least one of the user feedback data and the device feedback data; and
updating and determining the target battery management strategy from the at least one battery management strategy based on updated user profile data.

36. The method according to any one of claims 30 to 35, wherein when the battery analysis result comprises the battery analysis results of the M devices, the first interface further comprises one or more of the following information:
distribution information of the battery analysis results of the M devices; and
ranking information of the battery analysis results of the M devices.

37. The method according to claim 36, wherein the method further comprises:
sending prompt information to at least one device based on the battery analysis results of the M devices, wherein the at least one device is a device whose battery state of health meets a preset state of health, and the prompt information indicates the battery state of health corresponding to the device.

38. A battery management system, comprising a first device and a server, wherein
the first device comprises a plurality of functional modules, and the plurality of functional modules interact with each other to implement the method according to any one of claims 22 to 29; and
the server comprises a plurality of functional modules, and the plurality of functional modules interact with each other to implement the method according to any one of claims 30 to 37.

39. An electronic device, comprising at least one processor, wherein the at least one processor is coupled to at least one memory, and the at least one processor is configured to read and execute a computer program stored in the at least one memory, to implement the method according to any one of claims 22 to 29.

40. The electronic device according to claim 39, wherein the electronic device is a vehicle comprising a battery, or an energy storage device comprising an energy storage battery, or a mobile phone, or a tablet computer, or a notebook computer.

41. A server, comprising at least one processor, wherein the at least one processor is coupled to at least one memory, and the at least one processor is configured to read and execute a computer program stored in the at least one memory, to implement the method according to any one of claims 30 to 37.

42. A computer-readable storage medium, wherein the computer-readable storage medium stores instructions, and when the instructions are run on a computer, the computer is enabled to perform the method according to any one of claims 22 to 29, or the computer is enabled to perform the method according to any one of claims 30 to 37.

43. A computer program product comprising instructions, wherein when the computer program product runs on a computer, the computer is enabled to perform the method according to any one of claims 22 to 29, or the computer is enabled to perform the method according to any one of claims 30 to 37.
